(19) Europäisches Patentamt
European Patent Office
Office européen des brevets

(11) EP 1 771 042 A1

(12) # EUROPEAN PATENT APPLICATION
published in accordance with Art. 158(3) EPC

(43) Date of publication:
**04.04.2007 Bulletin 2007/14**

(21) Application number: **05765781.9**

(22) Date of filing: **13.07.2005**

(51) Int Cl.:
***H05B 33/12*** *(2006.01)* ***H05B 33/14*** *(2006.01)*
***H05B 33/24*** *(2006.01)*

(86) International application number:
**PCT/JP2005/012936**

(87) International publication number:
**WO 2006/009039 (26.01.2006 Gazette 2006/04)**

(84) Designated Contracting States:
**DE FR GB**

(30) Priority: **22.07.2004 JP 2004214482**

(71) Applicant: **IDEMITSU KOSAN CO., LTD.**
**Tokyo 100-8321 (JP)**

(72) Inventor: **KUMA, Hitoshi**
**Sodegaura-shi, Chiba 2990293 (JP)**

(74) Representative: **Gille Hrabal Struck Neidlein Prop Roos**
**Brucknerstrasse 20**
**40593 Düsseldorf (DE)**

(54) **COLOR LIGHT-EMITTING DEVICE**

(57) A color emitting device (1) comprising an emitting device (10) and a color conversion member (21) which absorbs light emitted from the emitting device (10) and emits light; the emitting device (10) including at least a first reflecting section (12) and a second reflecting section (15) provided in that order in a light-outcoupling direction, and an organic emitting layer (14) positioned between the first and second reflecting sections; the color conversion member (21) being positioned on a light-outcoupling side of the second reflecting section (15) ; and the emitting device (10) having a reflectance of 50% or more for a peak wavelength of the light emitted from the color conversion member (21).

FIG. 1

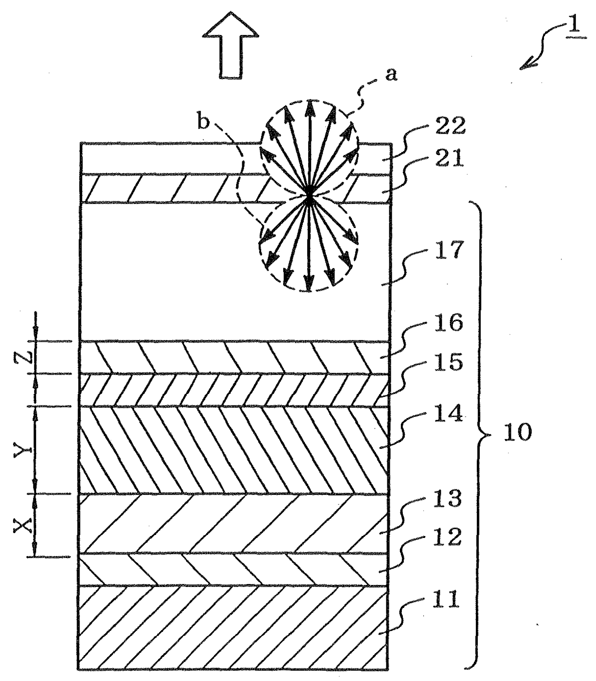


EP 1 771 042 A1

## Description

### TECHNICAL FIELD

The invention relates to a color emitting device. More particularly, the invention relates to a color emitting device suitable for a color display.

### BACKGROUND ART

A color conversion method, in which light emitted from an emitting device is converted into light having a different wavelength by a color conversion member, is used for an organic electroluminescent (hereinafter abbreviated as "EL") device, and is also useful for efficiently converting the color of light emitted from an emitting device (e.g. vacuum fluorescent display (VFD) or light emitting diode (LED)) or a liquid crystal display device.

Organic EL color emitting devices using the color conversion method are roughly divided into a bottom emission type and a top emission type.

FIG. 7 shows an example of a bottom emission type organic EL color emitting device. In the bottom emission type organic EL color emitting device, a color conversion member 70 and a thin film transistor (TFT) 72 are formed on a supporting substrate 71. A first electrode 73, an insulating member 74, an organic emitting layer 75, a second electrode 77, and a gas barrier layer 79 are further stacked on the supporting substrate 71 in that order, and a sealing substrate 80 is provided on the uppermost side.

The color conversion member 70 absorbs light emitted from the organic emitting layer 75 and emits light having a longer wavelength. The gas barrier layer 79 protects the organic emitting layer 75 from moisture and oxygen. In the bottom emission type organic EL color emitting device, the light emitted from the organic emitting layer is converted by the color conversion member 70, and the converted light is outcoupled through the supporting substrate 71. In FIG. 7, the arrow indicates the light-outcoupling direction.

FIG. 8 shows an example of a top emission type organic EL color emitting device.

In the top emission type organic EL color emitting device, the TFT 72 and the first electrode 73 are formed on the supporting substrate 71. The insulating member 74, the organic emitting layer 75, the second electrode 77, the gas barrier layer 79, a planarization layer 78, and the color conversion member 70 are further stacked on the supporting substrate 71 in that order, and the sealing substrate 80 is provided on the uppermost side.

In the top emission type organic EL color emitting device, light emitted from the organic emitting layer 75 is converted by the color conversion member 70, and the converted light is outcoupled through the sealing substrate 80.

In the top emission type organic EL color emitting device, since the TFT 72 is disposed on the supporting substrate 71 opposite to the light-outcoupling side (side of the sealing substrate), the organic EL material can be caused to emit light under moderate conditions (i.e. low current density) similar to those of DC drive without decreasing the aperture ratio.

As literature which discloses a top emission type organic EL color emitting device using a color conversion member, patent document 1 discloses an electrode having a large work function, such as a stacked electrode of aluminum and gold, as the first electrode, and a stacked electrode of magnesium-silver alloy or an alkali metal fluoride (lithium fluoride) and indium tin oxide (ITO) having a small work function and electron-injecting properties, as the second electrode.

However, when using an alkali metal fluoride such as lithium fluoride for the upper electrode, since the alkali metal fluoride is an insulator, the drive voltage is rapidly increased when increasing the film thickness. Therefore, the film thickness must be reduced to about 1 to 2 nm. However, when the film thickness is reduced to such a level, the organic emitting layer is extensively damaged when depositing the ITO electrode on the film, whereby the emission efficiency of the organic EL device is impaired.

Patent document 2 discloses a stacked anode of molybdenum and ITO as the first electrode and a stacked cathode of a magnesium-silver alloy thin film and ITO as the second electrode. Patent document 3 discloses an emitting device having a microcavity structure which introduces light emitted from an organic EL emitting section into a color conversion member, the microcavity structure having such an optical length that light having a broad spectrum is enhanced by the microcavity structure into light having a resonance peak which substantially overlaps the absorption peak.

According to these technologies, the efficiency of the organic EL device is relatively increased. However, when forming an emitting device using the color conversion member, since the intensity of light emitted from the emitting device is insufficient, the emitting device exhibits a low luminance. Therefore, a method which can more effectively improve the light intensity has been demanded.

[Patent document 1] JP-A-10-289784
[Patent document 2] JP-A-2000-77191
[Patent document 3] JP-A-2002-520801

The invention was achieved in view of the above-described problems. An object of the invention is to provide a color emitting device of which the luminance is increased by efficiently outcoupled light converted by a color conversion member from the device.

DISCLOSURE OF THE INVENTION

The inventors of the invention conducted extensive studies in order to achieve the above object. As a result, the inventors found that a decrease in the luminance in the emitting device occurs because light emitted from the color conversion member partly is attenuated in the emitting device to prevent efficient outcoupling of light from the device. FIG. 9 is a schematic diagram of an organic EL color emitting device using a color conversion member, and illustrates a state in which light emitted from the color conversion member is attenuated in the device.
In this color emitting device, an organic EL device 10 includes a first electrode 12, an organic emitting layer 14, a second electrode 15, and a gas barrier layer 17, in which the organic emitting layer 14 is placed between the first electrode 12 and the second electrode 15. A color conversion member 21 absorbs light from the organic EL device 10 and emits light.
Since the light emitted from the color conversion member 21 is spatially isotropic, the light emitted from the color conversion member 21 contains a component "a" emitted toward the light-outcoupling side (indicated by the arrow in FIG. 9) of the color emitting device, and a component "b" emitted toward the organic EL device 10. In the top emission type color emitting device, the electrodes are generally formed by a metal exhibiting high reflecting properties or a metal compound thin film having a high refractive index. The second electrode 15 must transmit light. In this case, light b' which is a part of the light component b is attenuated by multiple interference between the electrodes, and then disappears, so that the amount of light outcoupled from the device is decreased. As a result, the intensity of light emitted toward the viewer side (display surface) is decreased.
An emitting device, such as a vacuum fluorescent display (VFD), using an emission principle other than that of the organic EL device generally has a diffusion reflecting surface, and light emitted from the color conversion member toward the emitting device is attenuated without being reflected.
Based on the above findings, the inventors found that the intensity of light outcoupled from the device can be increased by increasing the reflectance of the emitting device for the peak wavelength of light emitted from the color conversion member. The inventors also found that the reflectance can be adjusted by the optical length between the first electrode and the second electrode forming the device, and the like. These findings have led to the completion of the invention.
The invention provides the following color emitting device.

1. A color emitting device comprising an emitting device and a color conversion member which absorbs light emitted from the emitting device and emits light; the emitting device including at least a first reflecting section and a second reflecting section provided in that order in a light-outcoupling direction, and an organic emitting layer positioned between the first and second reflecting sections; the color conversion member being positioned on a light-outcoupling side of the second reflecting section; and the emitting device having a reflectance of 50% or more for a peak wavelength of the light emitted from the color conversion member.
2. The color emitting device according to 1 above,
wherein the emitting device further includes a first transparent layer and a second transparent layer in that order in the light-outcoupling direction;
wherein the first transparent layer is positioned between the first and second reflecting sections; and
wherein the color conversion member is positioned on the light-outcoupling side of the second transparent layer.
3. The color emitting device according to 1 or 2 above,

wherein the second transparent layer is positioned between the second reflecting section and the color conversion member.
4. A color emitting device comprising:

a first pixel including a first emitting device and a first color filter in that order in a light-outcoupling direction, the first color filter transmitting light of a first color emitted from the first emitting device;
a second pixel including a second emitting device and a second color filter in that order in the light-outcoupling direction, the second color filter transmitting light of a second color emitted from the second emitting device; and
a third pixel including a third emitting device and a color conversion member in that order in the light-outcoupling direction, the color conversion member absorbing light emitted from the third emitting device and emitting light of a third color;

the first emitting device including at least a first reflecting section, an organic emitting layer, a second reflecting section, and a second transparent layer in that order in the light-outcoupling direction;
the second emitting device including at least the first reflecting section, a third transparent layer, the organic emitting layer, the second reflecting section, and the second transparent layer in that order in the light-outcoupling direction;
the third emitting device including at least the first reflecting section, a first transparent layer, the organic emitting layer, the second reflecting section, and the second transparent layer in that order in the light-outcoupling direction, the third emitting device having a reflectance of 50% or more for the light of the third color emitted from the color conversion member; and
the organic emitting layer including at least a first emitting material which emits the light of the first color and a second emitting material which emits the light of the second color.

5. The color emitting device according to 4 above, wherein the third emitting device further includes a third color filter which transmits the light of the third color.

6. A color emitting device comprising:

a first pixel including a first emitting device and a first color filter in that order in a light-outcoupling direction, the first color filter transmitting light of a first color emitted from the first emitting device;
a second pixel including a second emitting device and a color conversion member in that order in the light-outcoupling direction, the color conversion member absorbing light emitted from the second emitting device and emitting light of a second color; and
a third pixel including a third emitting device and a color conversion member in that order in the light-outcoupling direction, the color conversion member absorbing light emitted from the third emitting device and emitting light of a third color;
the first emitting device including at least a first reflecting section, an organic emitting layer, a second reflecting section, and a second transparent layer in that order in the light-outcoupling direction;
the second emitting device including at least the first reflecting section, a first transparent layer, the organic emitting layer, the second reflecting section, and the second transparent layer in that order in the light-outcoupling direction, the second emitting device having a reflectance of 50% or more for the light of the second color emitted from the color conversion member;
the third emitting device including at least the first reflecting section, the first transparent layer, the organic emitting layer, the second reflecting section, and the second transparent layer in that order in the light-outcoupling direction, the third emitting device having a reflectance of 50% or more for the light of the third color emitted from the color conversion member; and
the organic emitting layer including at least a first emitting material which emits the light of the first color.

7. The color emitting device according to 6 above, wherein the second emitting device includes a second color filter which transmits the light of the second color, and the third emitting device includes a third color filter which transmits the light of the third color.

8. The color emitting device according to any one of 2 to 7 above, wherein a sum "S1+S2" of a product S1 of a thickness of the first transparent layer and a refractive index of the first transparent layer for the light of the color emitted from the color conversion member and a product S2 of a thickness of the organic emitting layer and a refractive index of the organic emitting layer for the light of the color emitted from the color conversion member is 250 to 500 nm.
9. The color emitting device according to 8 above, wherein the product of the thickness of the first transparent layer and the refractive index of the first transparent layer for the light of the color emitted from the color conversion member is 100 to 350 nm.
10. The color emitting device according to 8 or 9 above, wherein the product of the thickness of the second transparent layer and the refractive index of the second transparent layer for the light of the color emitted from the color conversion member is 100 to 350 nm.

11. The color emitting device according to any one of 1 to 3 above, wherein the light emitted from the organic emitting layer is repeatedly reflected between the first and second reflecting sections so that light having an absorption wavelength of the color conversion member is selectively enhanced.

12. The color emitting device according to 4 or 5 above,
wherein, in the first emitting device, the light emitted from the organic emitting layer is repeatedly reflected between the first and second reflecting sections so that the light of the first color is selectively enhanced;
wherein, in the second emitting device, the light emitted from the organic emitting layer is repeatedly reflected between the first and second reflecting sections so that the light of the second color is selectively enhanced; and
wherein, in the third emitting device, the light emitted from the organic emitting layer is repeatedly reflected between the first and second reflecting sections so that light having an absorption wavelength of the color conversion member is selectively enhanced.

13. The color emitting device according to 6 or 7 above,
wherein, in the first emitting device, the light emitted from the organic emitting layer is repeatedly reflected between the first and second reflecting sections so that the light of the first color is selectively enhanced;
wherein, in the second emitting device, the light emitted from the organic emitting layer is repeatedly reflected between the first and second reflecting sections so that light having an absorption wavelength of the color conversion member is selectively enhanced; and
wherein, in the third emitting device, the light emitted from the organic emitting layer is repeatedly reflected between the first and second reflecting sections so that light having an absorption wavelength of the color conversion member is selectively enhanced.

14. The color emitting device according to any one of 1 to 13 above, wherein the first reflecting section has a reflectance of 65% or more for the light emitted from the color conversion member.

The color emitting device according to the invention can improve the luminance of the device itself, since light (fluorescence or phosphorescence) converted by the color conversion member can efficiently be outcoupled to the outside of the device.

BRIEF DESCRIPTION OF THE DRAWINGS

FIG. 1 is a diagram showing a configuration of a color emitting device according to the invention.
FIG. 2 is a graph showing the relationship between an optical length (L) and m in the equation (4).
FIG. 3 is a diagram showing the relationship among the optical length L, the reflectance of an organic EL device at 530 nm (light emitted from a green conversion member) and 610 nm (light emitted from a red conversion member), and the outcoupling efficiency of light having a wavelength of 460 nm which is outcoupled from the organic EL device.
FIG. 4 is a diagram showing the relationship between the optical length of a second transparent layer and the reflectance of the organic EL device for light having a wavelength of 530 nm and 610 nm when setting the optical length at 400 nm (region (B) in FIG. 3) by a first transparent layer and an organic emitting layer.
FIG. 5 is a diagram showing a configuration of a color emitting device according to one embodiment of the invention.
FIG. 6 is a diagram showing a configuration of a color emitting device according to another embodiment of the invention.
FIG. 7 is a diagram showing an example of a bottom emission type organic EL color emitting device.
FIG. 8 is a diagram showing an example of a top emission type organic EL color emitting device.
FIG. 9 is a diagram showing a state in which fluorescence emitted from a color conversion member attenuates in the device.

BEST MODE FOR CARRYING OUT THE INVENTION

A color emitting device according to the invention is described below with reference to the drawings.
FIG. 1 is a diagram showing a configuration of a color emitting device according to the invention.
A color emitting device 1 includes an organic EL device 10 and a color conversion member 21.
The organic EL device 10 has a configuration in which a supporting substrate 11, a first reflecting section 12, a first transparent layer 13, an organic emitting layer 14, a second reflecting section 15, a second transparent layer 16, and a gas barrier layer 17 are stacked in that order.
A transparent supporting substrate 22 supports the color conversion member 21.

The supporting substrate 11 supports the organic EL device. The first reflecting section 12 is a layer functioning as an electrode which supplies holes or electrons and reflecting light emitted from the organic emitting layer 14 in the light-outcoupling direction (direction indicated by the arrow in FIG. 1).

The first transparent layer 13 adjusts the optical length between the first reflecting section 12 and the second reflecting section 15. The first transparent layer 13 may also function as an electrode which supplies holes or electrons.
The organic emitting layer 14 is a layer including a luminescent medium layer (not shown) and emitting light upon recombination of electrons and holes. The second reflecting section 15 is a layer which reflects and transmits light emitted from the organic emitting layer 14. The second transparent layer 16 adjusts the reflectance of the organic EL device. The second reflecting section 15 and/or the second transparent layer 16 also function as an electrode which supplies holes or electrons.

The first transparent layer 13 is unnecessary when the optical length between the first reflecting section 12 and the second reflecting section 15 can be adjusted by adjusting the thickness of the organic emitting layer 14. The position of the second transparent layer 16 is not limited to the position shown in FIG. 1. The second transparent layer 16 may be formed between the organic emitting layer 14 and the second reflecting section 15, for example. However, if the second transparent layer 16 is formed on the organic emitting layer 14, the organic emitting layer 14 may be damaged when forming the second transparent layer 16. Therefore, it is preferable to form the second transparent layer 16 between the second reflecting section 15 and the color conversion member 21.
Another reflecting section may be formed in addition to the first reflecting section 12 and the second reflecting section 15.

The organic EL device 10 has an optical resonator structure in which a resonator is formed between the first reflecting section 12 and the second reflecting section 15. The optical resonator structure allows light emitted from the organic emitting layer 14 to be repeatedly reflected between the reflecting surfaces so that light having a wavelength in the vicinity of the wavelength satisfying the following equation (1) is selectively enhanced and emitted from the device.

$$(2L)/\lambda+(\Phi_1+\Phi_2)/(2\pi)=m \qquad (1)$$

Wherein, L indicates the optical length between the reflecting sections, $\lambda$ indicates the wavelength of the light, $\Phi_1$ and $\Phi_2$ respectively indicate the phase shift at the interface with the first reflecting section or the second reflecting section, and m indicates an integer.

The optical length L is the product of the refractive index and the actual geometrical length of the medium through which the light passes.
Specifically, light emitted from the organic emitting layer 14 and having a wavelength in the vicinity of the wavelength $\lambda$ satisfying the above equation is selectively enhanced, passes through the second reflecting section 15 and the second transparent layer 16, and is emitted from the device.

A method of calculating the optical length between the reflecting sections is described below. A thin film of a single material forming each member provided between the reflecting sections is formed on a supporting substrate. The resulting thin film sample is subjected to optical measurement using an ellipsometer or the like to determine the refractive index n of the material at a specific wavelength. Then, the product of the thickness d and the refractive index n of each layer when forming the organic EL device is calculated, and the optical length L is determined by calculating the sum of the products. In the case where k (k is an integer) thin films are provided between the reflecting sections, when the refractive index of each layer is indicated by $n_1, n_2, \ldots, n_k$ and the thickness of each layer is indicated by $d_1, d_2, \ldots, d_k$, the optical thickness L is calculated by the following equation (2).

$$L=n_1\times d_1+n_2\times d_2+\ldots+n_k\times d_k \qquad (2)$$

The phase shifts $\Phi_1$ and $\Phi_2$ are calculated as follows. A desired reflecting section is formed on a supporting substrate. The resulting thin film sample is subjected to optical measurement using an ellipsometer or the like to determine the refractive index no and the extinction coefficient $K_0$ of the material. In this case, when the refractive index of a layer contacting the reflecting section in the resonator structure is indicated by $n_1$, the phase shift $\Phi_1$ is calculated by the following equation (3).

$$\Phi_1 = \arctan\left(\frac{2n_1\kappa_0}{n_1^{\ 2}-n_0^{\ 2}-\kappa_0^{\ 2}}\right) \qquad (3)$$

The color emitting device 1 is configured so that the organic EL device 10 has a reflectance of 50% or more for the peak wavelength of light emitted from the color conversion member 21. A color emitting device having a practical display capability can be manufactured by setting the reflectance at 50% or more. The reflectance is preferably 60% or more, and particularly preferably 70% or more. Note that the reflectance is preferably 100% or less.

The "reflectance of the emitting device" used herein means the reflectance of light having a specific wavelength which is vertically incident on the surface of the emitting device toward the inside the emitting device. The reflectance refers to the reflectance of the entire emitting device, and indicates the sum of multiple reflection at each layer and each interface of the emitting device.

A method of setting the reflectance at 50% or more is described below in detail taking an example of a color emitting device formed by combining the organic EL device 10 including a blue emitting layer having a peak wavelength of 460 nm and the color conversion member 21 which absorbs light having a wavelength of 460 nm and emits light having a longer wavelength (red or green).

The organic EL device used for the following description has a configuration in which aluminum (thickness: 200 nm, refractive index: 1.04-6.51i (i is an imaginary unit)) as the first reflecting section 12, indium tin oxide (ITO) (thickness: X nm, refractive index: 1.89) as the first transparent layer 13, the organic emitting layer 14 (thickness: Y nm, refractive index: 1.76), a magnesium-silver alloy (thickness: 10 nm, refractive index: 0.57-3.47i) as the second reflecting section 15, and ITO (thickness: Z nm, refractive index: 1.89) as the second transparent layer 16 are stacked on the glass supporting substrate 11 in that order in the light-outcoupling direction.

The phase shift calculated by the equation (3) is -3.66 radians at the interface with the first reflecting section 12 (aluminum film) and is -0.92 radians at the interface with the second reflecting section 15 (magnesium-silver alloy film). The sum of the phase shifts $\Phi_1$ and $\Phi_2$ is -4.58 radians. Therefore, the equation (1) is expressed by the following equation (4).

$$(2L)/460-4.58/(2\pi)=m \qquad (4)$$

FIG. 2 is a graph showing the relationship between the optical length (L) and m in the equation (4). The points indicated by the arrows A, B, and C in FIG. 2 are points at which m in the equation (4) is an integer. Therefore, m equals to or near an integer by setting the optical length in the range of 150 to 200 nm (A), 380 to 420 nm (B), and 600 to 650 nm (C), so that the light emitted from the emitting layer 14 and having a wavelength of 460 nm is enhanced by the effect of the resonator structure, emitted from the organic EL device 10, and introduced into the color conversion member 21.

FIG. 3 is a diagram showing the relationship among the optical length L (=1.89X+1.76Y), the reflectance of the organic EL device at 530 nm (light emitted from a green conversion member) and 610 nm (light emitted from a red conversion member), and the outcoupling efficiency of light having a wavelength of 460 nm which is emitted from the organic EL device in this example. The graph shown in FIG. 3 is obtained by theoretical calculations.

In FIG. 3, (A) and (B) respectively correspond to A and B in FIG. 2, and indicate the regions in which light having a wavelength of 460 nm can be efficiently outcoupled from the organic EL device 10. When comparing the reflectance of the organic EL device 10 for light emitted from the color conversion member between the case where the optical length L is set at (A) and the case where the optical length L is set at (B), while the reflectance is lower than 50% at (A), the reflectance exceeds 50% at (B). Specifically, light having a specific wavelength (460 nm in this example) is enhanced by the organic EL device 10 by setting the optical length L at region (B), and the organic EL device 10 reflects the light component "b" emitted from the color conversion member 21 while supplying light to the color conversion member 21, so that light can be efficiently outcoupled from the color emitting device.

In the invention, the optical length L is adjusted so that m in the equation (1) becomes an integer so that light emitted from the organic emitting layer and having a specific wavelength (e.g. blue light at 460 nm) is enhanced, and the reflectance for the peak wavelength (e.g. red light at 610 nm) of light emitted from the color conversion member 21 is 50% or more. The reflectance may also be adjusted by appropriately selecting the material for each layer (e.g. first reflecting section 12) in addition to adjusting the optical length L.

In this example, the optical length L may be expressed by "L=1.89X+1.76Y (L=S1+S2)". In order to set the optical length L at region (B), the thickness X of the first transparent layer 13 and the thickness Y of the organic emitting layer 14 may be appropriately adjusted.

A specific value of the optical length L differs depending on the materials used for the organic EL device, their wavelength dispersion properties, and the order of layers. The optical length L, which is the sum of the optical length S1, which is the product of the thickness (unit: nm) of the first transparent layer and the refractive index of the first transparent layer for light of a color emitted from the color conversion member, and the optical length S2, which is the product of the thickness (unit: nm) of the organic emitting layer and the refractive index of the organic emitting layer for light of a color emitted from the color conversion member, is preferably 250 to 500 nm, and particularly preferably 300 to 450 nm.

The optical length S1 is preferably 100 to 350 nm, and particularly preferably 130 to 300 nm. If the optical length S1 is less than 100 nm, the thickness of the organic emitting layer is relatively increased, whereby the drive voltage of the device may be increased. If the optical length S1 exceeds 300 nm, the thickness of the organic emitting layer is relatively decreased, whereby the continuous driving lifetime of the color emitting device may be decreased or yield may be decreased.

FIG. 4 is a diagram showing the relationship between the optical length of the second transparent layer 16 and the reflectance of the organic EL device for light having a wavelength of 530 nm and 610 nm when setting the optical length at 400 nm (region (B) in FIG. 3) by the first transparent layer 13 and the organic emitting layer 14. The graph shown in FIG. 4 is the result obtained by theoretical calculations.

The reflectance of the organic EL device 10 can also be adjusted by changing the optical length by adjusting the thickness of the second transparent layer 16.

A specific value of the optical length of the second transparent layer 16 differs depending on the materials used for the organic EL device 10, their wavelength dispersion properties, the order of layers, and the color of light emitted from the color conversion member 21. It is preferable that the product (optical length) of the thickness (unit: nm) of the second transparent layer and the refractive index of the second transparent layer for light of the color emitted from the color conversion member be 100 to 300 nm, and particularly preferably 120 to 280 nm.

In the color emitting device according to the invention, light emitted from the color conversion member can be efficiently outcoupled from the device, even if the color conversion member is combined with the emitting device. Therefore, the amount of light outcoupled from the emitting device is increased, so that a color emitting device exhibiting a high luminance can be obtained.

Embodiments in which the invention is applied to a full color emitting device are described below.

First Embodiment

FIG. 5 is a diagram showing a configuration of a color emitting device according to one embodiment of the invention.

The first embodiment is an example of a full color emitting device in which pixels respectively emitting light of blue, green, red of the three primary colors are separately arranged in a plane by using the technology according to the invention.

In a color emitting device 2, a blue pixel 101, a green pixel 102, and a red pixel 103 are formed on the supporting substrate 11. The arrow indicates the light-outcoupling direction.

The blue pixel 101 includes a first organic EL device 41 and a blue color filter 51. The first organic EL device 41 has a configuration in which the first reflecting section 12, the organic emitting layer 14, the second reflecting section 15, the second transparent layer 16, and the gas barrier layer 17 are stacked in that order.

The green pixel 102 includes a second organic EL device 42 and a green color filter 52. The second organic EL device 42 has the same configuration as the first organic EL device 41 except that a third transparent layer 13' is formed between the first reflecting section 12 and the organic emitting layer 14.

The red pixel 103 includes a third organic EL device 43, a red conversion member 33, and a red color filter 53. The third organic EL device 43 has the same configuration as the first organic EL device 41 except that the first transparent layer 13 is formed between the first reflecting section 12 and the organic emitting layer 14.

The members of the color emitting device 2 are the same as the corresponding members shown in FIG. 1.

In FIGS. 3 and 4, the reflectance for light emitted from the green conversion member and having a wavelength of 530 nm is generally lower than the reflectance for light emitted from the red conversion member and having a wavelength of 610 nm. In this case, it is preferable that the red pixel 103 have a configuration as shown in FIG. 1 and the blue pixel 101 and the green pixel 102 have a configuration in which only the color filter is used without using the color conversion member.

The organic emitting layer 14 emits light including at least blue light and green light. Since the blue color filter 51 is disposed in the blue pixel 101 and the green color filter 52 is disposed in the green pixel 102, the color corresponding to each pixel can be outcoupled from the emitting device.

The thickness of the organic emitting layer 14 is set so that m in the equation (1) is an integer when setting the wavelength $\lambda$ at the wavelength of blue light. This allows only the blue light emitted from the organic emitting layer 14 to be selectively enhanced by the optical resonator effect. In the blue pixel 101, the enhanced blue light passes through the blue color filter 51 and is emitted from the emitting device.

In the green pixel 102, the third transparent layer 13' having an optical length differing from the optical length of the first transparent layer 13 is provided on the first reflecting section 12. Only the green light emitted from the organic emitting layer 14 can be selectively enhanced by setting the thickness of the third transparent layer 13' so that m is an integer when setting the wavelength $\lambda$ at the wavelength of green light. In the green pixel 102, the enhanced green light passes through the green color filter 52 and is emitted from the emitting device.

In the red pixel 103, the first transparent layer 13 is provided on the first reflecting section 12. Only light emitted

from the organic emitting layer 14 and having the absorption wavelength of the red conversion member 33 can be selectively enhanced by setting the thickness of the first transparent layer 13 so that m in the equation (1) is an integer when setting the wavelength λ at the absorption wavelength of the red conversion member 33. In the red pixel 103, the enhanced light is converted into red light by the red conversion member 33, passes through the red color filter 53, and is emitted from the emitting device.

In this embodiment, the third organic EL device 43 has a reflectance of 50% or more for the peak wavelength of light emitted from the red conversion member 33. Therefore, the red light can be efficiently outcoupled from the device.

Since each of the three primary colors can be enhanced as described above, a full color emitting device exhibiting a high luminance can be obtained.

In this embodiment, a full color emitting device can also be obtained by using only the green conversion member as the color conversion member and an organic emitting layer which emits at least blue light and red light as the organic emitting layer 14.

In this embodiment, the red color filter 53 is formed in the red pixel 103. The red color filter 53 may not be formed when the chromatic purity of the color of light emitted from the red conversion member 33 is high, for example.

Second Embodiment

A second embodiment is another example of a full color emitting device in which emitting pixels respectively emitting light of blue, green, red of the three primary colors are separately arranged in a plane.

A full color emitting device 3 has the same configuration as the full color emitting device according to the first embodiment except that the green pixel 102 includes a green conversion member 32 formed between the second organic EL device 42 and the green color filter 52, and the first transparent layer 13 is formed instead of the third transparent layer 13'. The members of the full color emitting device 3 are the same as the corresponding members shown in FIG. 2.

When the reflectance for the peak wavelength of light emitted from the green conversion member 32 and the reflectance for the peak wavelength of light emitted from the red conversion member 33 can be set at 50% or more, a configuration may be employed in which the green conversion member 33 and the red conversion member 32 are used in combination and the blue color filter 51 is disposed in only the blue pixel 101.

In this case, it suffices that the organic emitting layer 14 include a layer which emits at least blue light. The thickness of the organic emitting layer 14 is set so that the blue light is selectively enhanced. In the green pixel and the red pixel, the common first transparent layer 13 is provided on the first reflecting section 12. The thickness of the first transparent layer 13 is set so that only light emitted from the organic emitting layer 14 and having the absorption wavelengths of the green conversion member 32 and the red conversion member 33 is selectively enhanced. In this case, a material which absorbs light in the blue region and emits fluorescence is preferably used for the color conversion members 32 and 33.

In this embodiment, the second and third organic EL devices 42 and 43 have a reflectance of 50% or more for the peak wavelength of light emitted from the green conversion member 32 and the peak wavelength of light emitted from the red conversion member 33, respectively. Therefore, the green light and the red light can be efficiently outcoupled from the device.

Since each of the three primary colors can be enhanced as described above, a full color emitting device exhibiting a high luminance can be obtained.

In this embodiment, the color filters are formed in the green pixel 102 and the red pixel 103. The color filter may not be formed when the color purity of light emitted from the color conversion member is high, for example.

The above-described embodiments illustrate the top emission type color emitting devices. The invention may also be applied to a bottom emission type color emitting device.

Members included in the color emitting device of the invention will be described below.

1. Supporting substrate

The supporting substrate is a member for supporting the organic EL device, TFT and the like. Therefore the substrate is preferably excellent in mechanical strength and dimension stability.

Specific examples of such a substrate include glass plates, metal plates, ceramic plates and plastic plates such as polycarbonate resins, acrylic resins, vinyl chloride resins, polyethylene terephthalate resins, polyimide resins, polyester resins, epoxy resins, phenol resins and silicon resins, fluorine-containing resins.

In order to avoid the invasion of moisture into the color emitting device, the substrate made of these materials is preferably subjected to a moisture proof treatment or hydrophobic treatment by forming an inorganic film or applying a fluorine-containing resin.

In particular, in order to avoid the invasion of moisture into the organic luminescent medium layer, the substrate preferably has a small water content and gas permeability coefficient. Specifically, preferred water content and gas permeability coefficient are 0.0001% by weight or less and $1 \times 10^{-13}$ cc·cm/cm$^2$·sec·cmHg or less, respectively.

Since light is outcoupled from the opposite side of the supporting substrate in this embodiment, that is, EL emission is outcoupled from the second transparent electrode side, the supporting substrate is not necessarily transparent.

2. Organic EL device

(1) Organic emitting layer

An organic emitting layer can be defined as a layer including a medium which can generate EL emission due to recombination of electrons and holes each injected from an anode or a cathode. Such an organic emitting layer may be formed by stacking the following layers on the anode.

1. Organic emitting medium
2. Hole-injecting layer/organic emitting medium
3. Organic emitting medium/electron-injecting layer
4. Hole-injecting layer/organic emitting medium/electron-injecting layer
5. Hole-injecting layer/hole-transporting layer/organic emitting medium/electron-injecting layer
6. Hole-injecting layer/organic emitting medium/electron-transporting layer/electron-injecting layer
7. Hole-injecting layer/hole-transporting layer/organic emitting medium/electron-transporting layer/electron-injecting layer
8. Organic semiconductor layer/ organic emitting medium
9. Organic semiconductor layer/electron barrier layer/organic emitting medium
10. Hole-injecting layer/organic emitting medium/adhesion-improving layer

Of these, constitutions 1 to 7 are usually preferably used because of higher luminance and excellent durability.
The organic emitting layer may emit any color of light insofar as it can excite a color conversion member as mentioned later and cause the color conversion member to emit different color of light. From the viewpoint that a full-color image can be attained by the combination of the color conversion member, the organic emitting layer preferably includes at least blue emitting layer. The peak wavelength of light emitted from the blue emitting layer is preferably 400 to 500 nm, more preferably 440 to 480 nm.
The color emitting device according to the above-mentioned embodiment 2 may optionally include a green emitting layer having a peak wavelength of 500 to 580 nm or a red emitting layer having a peak wavelength of 580 nm or more, in addition to the blue emitting layer. Specifically, the organic emitting medium may be formed as a stacked structure of the blue emitting layer and the green emitting layer. Alternatively, it may be constituted such that the hole-transporting layer or the electron-transporting layer emits blue or green light.
Each constitution member will be described below.

(a) Blue emitting layer

The blue emitting layer contains a host material and a blue dopant.
The host material is preferably a styryl derivative, an anthracene derivative, or an aromatic amine. The styryl derivative is in particular preferably at least one selected from distyryl derivatives, tristyryl derivatives, tetrastyryl derivatives, and styrylamine derivatives. The anthracene derivative is preferably an asymmetric anthracene compound. The aromatic amine is preferably a compound having 2 to 4 nitrogen atoms which are aromatically substituted, and is in particular preferably a compound having 2 to 4 nitrogen atoms which are aromatically substituted, and having at least one alkenyl group.
The asymmetric anthracene compound preferably includes compounds represented by the following formula. The methods of preparing of the above-mentioned compounds are specifically described in Japanese Patent Application No. 2004-042694.
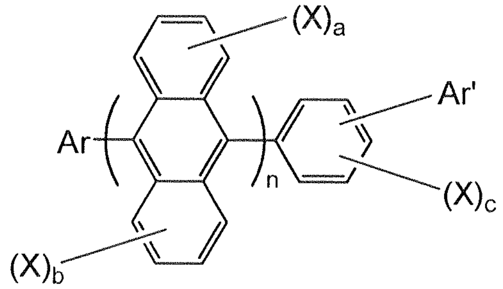

wherein Ar is a substituted or substituted condensed aromatic group having 10 to 50 nucleus carbon atoms,
Ar' is a substituted or unsubstituted aryl group having 6 to 50 nucleus carbon atoms,
X is a substituted or unsubstituted aryl group having 6 to 50 nucleus carbon atoms, substituted or unsubstituted aromatic heterocyclic group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nucleus atoms, a substituted or unsubstituted arylthio group having 5 to 50 nucleus atoms, a substituted or unsubstituted alkoxycarbonyl group having 1 to 50 carbon atoms, a carboxyl group, a halogen atom, a cyano group, a nitro group or a hydroxyl group.
a, b and c are each an integer of 0 to 4 and n is an integer of 1 to 3.

Examples of the substituted or unsubstituted condensed aromatic group of Ar in the above formula include 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 3-methyl-2-naphthyl, 4-methyl-1-naphthyl, and 4-methyl-l-anthryl groups.

Examples of the substituted or unsubstituted aryl group for Ar' in the above formula, the substituted or unsubstituted aryl, aromatic heterocyclic, alkyl, alkoxy, aralkyl, aryloxy, arylthio and alkoxycarbonyl groups for X include the following compounds.

Examples of the substituted or unsubstituted aryl group include phenyl, 1-naphthyl, 2-naphtyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pirenyl, 2-pirenyl, 4-pirenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphtyl, 4-methyl-1-naphty 4-methyl-1-anthryl, 4'-methylbiphenylyl and 4"-t-butyl-p-terphenyl-4-yl groups.

Examples of the substituted or unsubstituted aromatic heterocyclic group include 1-pyrrolyl, 2-pyrrolyl, 3-pyrrolyl, pyrazinyl, 2-pyrazinyl, 3-pyrazinyl, 4-pyrazinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthrezinyl, 2-phenanthrezinyl, 3-phenanthrezinyl, 4-phenanthrezinyl, 6-phenanthrezinyl, 7-phenanthrezinyl, 8-phenanthrezinyl, 9-phenanthrezinyl, 10-phenanthrezinyl, 1-acridinyl, 2-acridinyl, 3-acridinyl, 4-acridinyl, 9-acridinyl, 1,7-phenanthroline-2-yl, 1,7-phenanthroline-3-yl, 1,7-phenanthroline-4-yl, 1,7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthraline-6-yl, 1,8-phenanthroline-7-yl, 1,8-phenanthroline-9-yl, 1,8-phenanthroline-10-yl, 1,9-phenanthroline-2-yl, 1,9-phenanthrol-ine-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthroline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthraline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl1-indolyl, 4-t-butyl1-indolyl, 2-t-butyl3-indolyl and 4-t-butyl3-indolyl groups.

Examples of the substituted or unsubstituted alkyl group include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diisodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1.,2,3-triaminopropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3--tricyanopropyl, nitromethyl, 1-nitroethyl, 2-nitroethyl, 2-nitroisobutyl, 1,2-dinitroethyl, 1,3-dinitroisopropyl, 2,3-dinitra-t-butyl, 1,2.,3-trinitropropyl, cyclopropyl, cyclobutyl, cyclopentyl, cyclohexyl, 4-methylcyclohexyl, 1-adamantyl, 2-adamantyl, 1-nobornyl, and 2-nobornyl groups.

The substituted or unsubstituted alkoxy group are represented by -OY. Examples of Y include the same groups as the above-mentioned substituted or unsubstituted alkyl groups.

Examples of the substituted or unsubstituted aralkyl group include the above-mentioned substituted or unsubstituted alkyl groups which are substituted by the above-mentioned substituted or unsubstituted aryl groups.

The substituted or unsubstituted aryloxy group is represented by -OY'. Examples of Y' include the same groups as the above-mentioned substituted or unsubstituted aryl groups.

The substituted or unsubstituted arylthio group is represented by -SY'. Examples of Y' include the same groups as the above-mentioned substituted or unsubstituted alkyl groups.

The substituted or unsubstituted alkoxycarbonyl group is represented by -COOY. Examples of Y include the same groups as the above-mentioned substituted or unsubstituted alkyl groups.

As a halogen atom, fluoride, chlorine, bromine and iodine are exemplified.

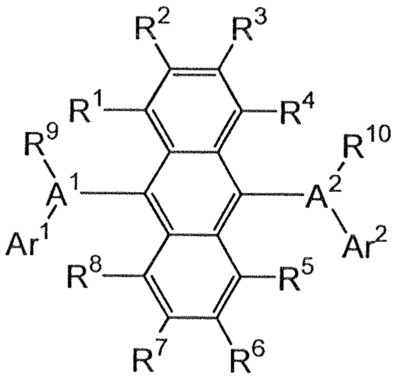

wherein $A^1$ and $A^2$ are independently a substituted or unsubstituted condensed aromatic group having 10 to 20 nucleus carbon atoms,

$Ar^1$ and $Ar^2$ are independently a hydrogen atom or a substituted or unsubstituted aryl group with 6 to 50 nucleus carbon atoms, and

$R^1$ to $R^{10}$ are independently a substituted or unsubstituted aryl group having 6 to 50 nucleus carbon atoms, a substituted or unsubstituted aromatic heterocyclic group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nucleus atoms, a substituted or unsubstituted arylthio group having 5 to 50 nucleus atoms, a substituted or unsubstituted alkoxycarbonyl group having 1 to 50 carbon atoms, a carboxyl group, a halogen atom, a cyano group, a nitro group or a hydroxyl group,

provided that groups do not symmetrically bond to 9 and 10 positions of the central anthracene.

Examples of the substituted or unsubstituted condensed aromatic group for $A^1$ and $A^2$ in the above formula include the same groups mentioned above.

Examples of the substituted or unsubstituted aryl group for $A^1$ and $A^2$ in the above formula include the same groups mentioned above.

Examples of the substituted or unsubstituted aryl, aromatic heterocyclic, alkyl, alkoxy, aralkyl, aryloxy, arylthio, and

alkoxy carbonyl groups for $R^1$ to $R^{10}$ in the above formula include the same groups mentioned above.

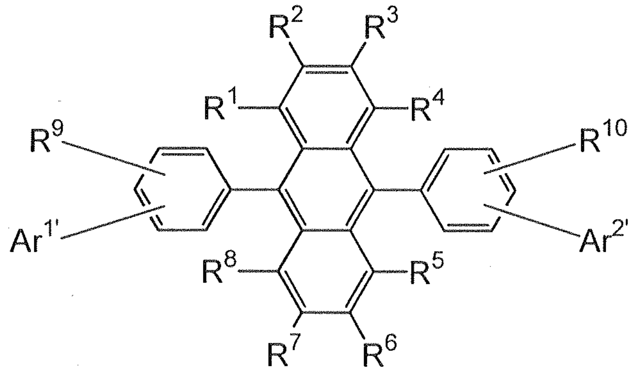

wherein $Ar^{1'}$ and Ar $^2$ are independently a substituted or unsubstituted aryl group having 6 to 50 nucleus carbon atoms, and $R^1$ to $R^{10}$ are independently a substituted or unsubstituted aryl group having 6 to 50 nucleus carbon atoms, a substituted or unsubstituted aromatic heterocyclic group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nucleus atoms, a substituted or unsubstituted arylthio group having 5 to 50 nucleus atoms, a substituted or unsubstituted alkoxycarbonyl group having 1 to 50 carbon atoms, a carboxyl group, a halogen atom, a cyano group, a nitro group or a hydroxyl group.

Examples of the substituted or unsubstituted aryl group of $Ar^{1'}$ and Ar 2 in the above formula include the above-mentioned examples.

Examples of the substituted or unsubstituted aryl, aromatic heterocyclic, alkyl, alkoxy, aralkyl, aryloxy, arylthio and alkoxycarbonyl groups for $R^1$ to $R^{10}$ in the above formula include the above-mentioned examples.

Examples of substituents for each of the above groups in the above formulas include halogen atoms, hydroxyl, nitro, cyano, alkyl, aryl, cycloalkyl, alkoxy, aromatic heterocyclic, aralkyl, aryloxy, arylthio, alkoxycarbonyl and carboxyl groups.

The blue dopant is preferably at least one compound selected from styrylamines, amine-substituted styryl compounds, amine-substituted condensed aromatic rings and condensed-aromatic-ring containing compounds. The blue dopant may be composed of plural compounds.

Examples of the styrylamines and amine-substituted styryl compounds are compounds represented by formulas (1) and (2), and examples of condensed-aromatic-ring containing compounds are compounds represented by formula (3).

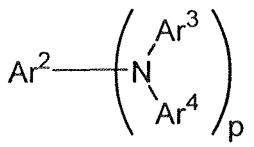

(1)

wherein $Ar^2$, $Ar^3$ and $Ar^4$ are independently a substituted or unsubstituted aromatic group having 6 to 40 carbon atoms and at least one thereof contains a styryl group; and p is an integer of 1 to 3.

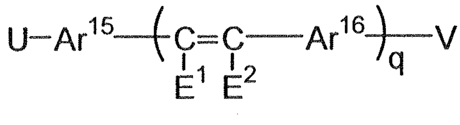

(2)

wherein $Ar^{15}$ and $Ar^{16}$ are independently a substituted or unsubstituted arylene group having 6 to 30 carbon

atoms, $E^1$ and $E^2$ are independently a substituted or unsubstituted aryl or alkyl group having 6 to 30 carbon atoms, a hydrogen atom or a cyano group; q is an integer of 1 to 3; and U and/or V is a substituent containing an amino group and the amino group is preferably an arylamino group.

$$(A)_r - B \qquad (3)$$

wherein A is an alkyl or alkoxy group having 1 to 16 carbon atoms, a substituted or unsubstituted aryl group having 6 to 30 carbon atoms, a substituted or unsubstituted alkylamino group having 6 to 30 carbon atoms or a substituted or unsubstituted arylamino group having 6 to 30 carbon atoms; B is a condensed aromatic group having 10 to 40 carbon atoms; and r is an integer of 1 to 4.

(b) Green emitting layer

The green emitting layer contains a host material and a green dopant.
It is preferred to use, as the host material, the same host material as used in the blue emitting layer from the viewpoint of reducing color change during continuous lighting.

The dopant is not particularly limited, and, for example, the following can be used: coumalin derivatives disclosed in EP-A- 0281381, JP-A-2003-249372, and others; and aromatic amine derivatives wherein a substituted anthracene structure and an amine structure are linked to each other.

(c) Orange-red emitting layer

An orange-red emitting layer contains a host material and an orange-red dopant.
It is preferred to use, as the host material, the same host material as used in the blue emitting layer from the viewpoint of reducing color change during continuous lighting.

As the dopant, there can be used a fluorescent compound having at least one fluoranthene skeleton or perylene skeleton, for example, compounds represented by the following formula:

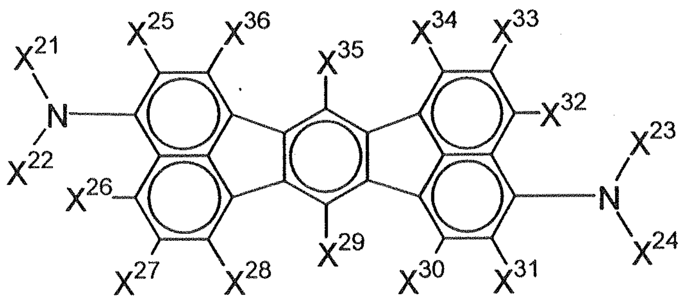

wherein $X^{21}$ to $X^{24}$ are independently an alkyl group having 1 to 20 carbon atoms or a substituted or unsubstituted aryl group having 6 to 30 carbon atoms; $X^{21}$ and $X^{22}$ and/or $X^{23}$ and $X^{24}$ may be bonded via a carbon-carbon bond, -O- or -S-; $X^{25}$ to $X^{36}$ are a hydrogen atom, a linear, branched or cyclic alkyl group having 1 to 20 carbon atoms, a linear, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms or a substituted or unsubstituted alkenyl group having 8 to 30 carbon atoms; adjacent substituents and $X^{25}$ to $X^{36}$ may be bonded to form a cyclic structure; and at least one of the substituents $X^{25}$ to $X^{36}$ in each of the formulas preferably contain an amine or alkenyl group.

(d) Hole-transporting layer

In the invention, a hole-transporting layer may be provided between the organic electroluminescent medium layer and the hole-injecting layer.
Such a hole-transporting layer is preferably made of a material which can transport holes to the emitting layer at lower electric field intensity. The hole mobility thereof is preferably at least $10^{-4}$ $cm^2/V \cdot$second when an electric field of $_{10}{}^4$ to $10^6$ V/cm is applied.
The material for forming the hole-transporting layer can be arbitrarily selected from materials which have been widely used as a hole-transporting material in photoconductive materials and known materials used in a hole-transporting layer of organic EL elements.
Specific examples thereof include triazole derivatives (see USP No. 3, 112, 197 and others), oxadiazole derivatives (see USP No. 3,189,447 and others), imidazole derivatives (see JP-B-37-16096 and others), polyarylalkane derivatives (see USP Nos. 3,615,402, 3,820,989.and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4, 232, 103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3, 526, 501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950, 950), polysilanes (JP-A-2-204996), aniline copolymers (JP-A-2-282263), and electroconductive oligomers (in particular thiophene oligomers) disclosed in JP-A-1-211399.
The thickness of the hole-transporting layer is not particularly limited but is preferably 5 nm to 5 μm, particularly preferably 5 to 40 nm. The hole-transporting layer may be a single layer made of one kind or two or more kinds of the above-mentioned materials. The hole-transporting layers made of different compound may be stacked.

(e) Hole-injecting layer

The same material for forming the hole-transporting layer can be used as the material of the hole-injecting layer. The following are preferably used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.
The following can also be given as examples: 4,4'-bis(N-(1-naphthyl)-N-phenylamino)biphenyl (hereinafter abbreviated to NPD), which has in the molecule thereof two condensed aromatic rings, disclosed in USP No. 5,061,569, and 4,4',4"-tris(N-(3-methylphenyl)-N-phenylamino)triphenylamin e (hereinafter abbreviated to MTDATA), wherein three triphenylamine units are linked to each other in a star-burst form, disclosed in JP-A-4-308688.
In addition to aromatic dimethylidene type compounds, inorganic compounds such as p-type Si and p-type SiC can also be used as the material of the hole-injecting layer. The organic semiconductor layer is a part of the hole-injecting layer, is a layer for helping the injection of holes or electrons into the emitting layer, and is preferably a layer having an electroconductivity of $10^{-10}$ S/cm or more. The material of such an organic semiconductor layer may be an electroconductive oligomer, such as thiophene-containing oligomer or arylamine-containing oligomer disclosed in JP-A-8-193191, an electroconductive dendrimer such as arylamine-containing dendrimer.
The thickness of the hole-injecting layer is preferably 10 to 1000 nm in order to avoid damage to the anode during its formation. It is more preferably 60 to 300 nm, still more preferably 100 to 200 nm.
The hole-injecting layer may be a single layer made of one kind or two or more kinds of the above-mentioned materials. Alternatively, the hole-injecting layer may be a layer in which another hole-injecting layer made of different compound is stacked on the above-mentioned hole-transporting layer.

(f) Electron-transporting layer

In the invention, an electron-transporting layer may be provided between the cathode and the organic electroluminescent medium layer.
The thickness of electron-transporting layer is properly selected several nm to several μm but is preferably selected

such that the electron mobility is $10^{-5}$ $cm^2/Vs$ or more when applied with an electric field of $10^4$ to $10^6$ V/cm.

The material used in the electron-transporting layer is preferably a metal complex of 8-hydroxyquinoline or a derivative thereof.

Specific examples of the above-mentioned metal complex of 8-hydroxyquinoline or derivative thereof include metal chelate oxynoid compounds containing a chelate of oxine (generally, 8-quinolinol or 8-hydroxyquinoline).

For example, tris(8-quinolinol)aluminum(Alq) as described in the explanation of the emitting material can be used for the electron-injecting layer.

Examples of the oxadiazole derivative include electron-transferring compounds represented by the following general formulas.

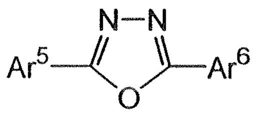

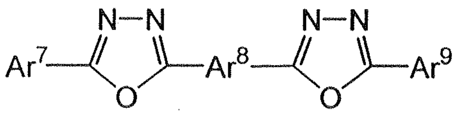

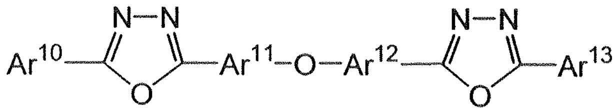

wherein $Ar^5$, $Ar^6$, $Ar^7$, $Ar^9$, $Ar^{10}$ and $Ar^{13}$ each represent a substituted or unsubstituted aryl group and may be the same or different, and $Ar^8$, $Ar^{11}$ and $Ar^{12}$ represent a substituted or unsubstituted arylene group and may be the same or different.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbon atoms, alkoxy groups with 1 to 10 carbon atoms, and a cyano group. The electron-transferring compounds are preferably ones having capability of forming a thin film.

Specific examples of the electron-transferring compounds include the following.

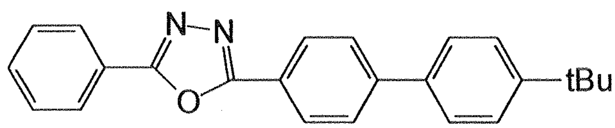

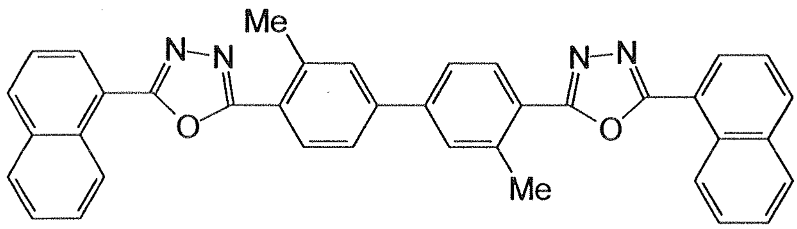

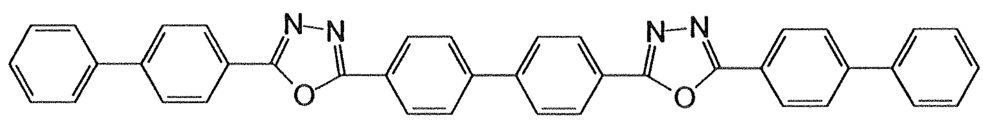

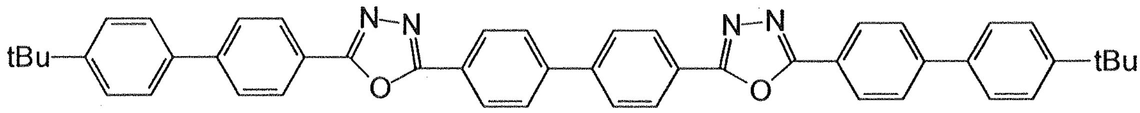

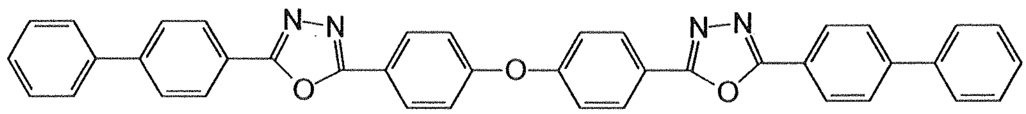

wherein Me is methyl and tBu is t-butyl.

Nitrogen-containing heterocyclic derivatives represented by the following formula:

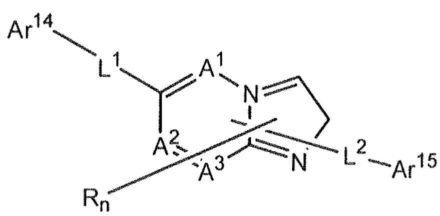

wherein $A^1$ to $A^3$ are independently a nitrogen atom or a carbon atom; R is a aryl group having 6 to 60 carbon atoms which may have a substituent, a heteroaryl group having 3 to 60 carbon atoms which may have a substituent, an alkyl group having 1 to 20 carbon atoms, a haloalkyl group having 1 to 20 carbon atoms or an alkoxy group having 1 to 20 carbon atoms; n is an integer of 0 to 5; when n is an integer of 2 or more, Rs may be the same or different; adjacent Rs may be bonded to each other to form a substituted or unsubstituted carbon aliphatic ring or a substituted or unsubstituted carbon aromatic ring; $Ar^{14}$ is a substituted or unsubstituted aryl group having 6 to 60 carbon atoms or a substituted or unsubstituted heteroaryl group having 3 to 60 carbon atoms; $Ar^{15}$ is a hydrogen atom, an alkyl group having 1 to 20 carbon atoms, a haloalkyl group having 1 to 20 carbon atoms, an alkoxy group having 1 to 20 carbon atoms, an aryl group having 6 to 60 carbon atoms which may have a substituent or a heteroaryl group having 3 to 60 carbon atoms which may have a substituent; provided that one of $Ar^{14}$ and $Ar^{15}$ is a substituted or unsubstituted condensed ring having 10 to 60 carbon atoms or a substituted or unsubstituted hetero condensed ring having 3 to 60 carbon atoms;
$L^1$ and $L^2$ are independently a single bond, a substituted or unsubstituted condensed ring having 6 to 60 carbon atoms, a substituted or unsubstituted hetero condensed ring having 3 to 60 carbon atoms or a substituted or unsubstituted fluorenylene group.

Nitrogen-containing heterocyclic derivatives represented by the following formula:

$$HAr\text{-}L^3\text{-}Ar^{16}\text{-}Ar^{17}$$

wherein HAr is a nitrogen-containing heterocyclic ring with 3 to 40 carbon atoms which may have a substituent; $L^3$ is a single bond, an arylane group with 6 to 60 carbon atoms which may have a substituent, a heteroarylane group with 3 to 60 carbon atoms which may have a substituent or a fluorenylene group which may have a substituent;
$Ar^{16}$ is a bivalent aromatic hydrocarbon group with 6 to 60 carbon atoms which may have a substituent; and
$Ar^{17}$ is an aryl group with 6 to 60 carbon atoms which may have a substituent or a heteroaryl group with 3 to 60 carbon atoms which may have a substituent.

(g) Electron-injecting layer

In the invention, an electron-injecting layer which is formed of an insulator or a semiconductor may further be provided between a cathode and an organic layer. By providing such an electron-injecting layer, current leakage can be effectively prevented to improve the injection of electrons.
As the insulator, a single metal compound or a combination of metal compounds selected from alkali metal calcogenides, alkaline earth metal calcogenides, halides of alkali metals, halides of alkaline earth metals, aluminum oxide, aluminum

nitride, titanium oxide, silicon dioxide, germanium oxide, silicon nitride, boron nitride, molybdenum oxide, ruthenium oxide and vanadium oxide can be preferably used. Among these metal compounds, if an electron-injecting layer is formed of the alkali metal calcogenides or alkaline earth metal calcogenides, the injection of electrons can be preferably improved. Preferable alkali metal calcogenides include $Li_2O$, LiO, $Na_2S$, $Na_2Se$ and NaO. Preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as $CaF_2$, $BaF_2$, $SrF_2$, $MgF_2$ and $BeF_2$ and halides other than fluorides.

Examples of the semiconductor for forming the electron-injecting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof.

The electron-transporting layer is preferably a microcrystalline or amorphous. Because a more uniform thin film can be formed to reduce pixel defects such as dark spots.

Two or more electron-injecting layers may be stacked.

The thickness of the organic emitting layer may be set preferably within a range of 5 nm to 5 μm such that the reflectance of the organic emitting layer for the peak wavelength of light emitted from the color conversion member becomes 50% or more. When the thickness of the organic emitting layer is less than 5 nm, luminance or durability may decrease. On the other hand, when the thickness of the organic emitting layer exceeds 5 μm, applied voltage may increase. Therefore, the thickness of the organic emitting layer is more preferably 10 nm to 3 μm, still more preferably 20 nm to 1 μm.

(2) First reflecting section

The material for a first reflecting section includes metal films having a large light reflectivity and dielectric multilayered films composed of films having different refractive index. Of these, the metal films are preferred from the viewpoint that high reflectance can be obtained within a broad range of visible light from blue to red.

The reflectance of the metal film is determined by the thickness d, complex refractive index n-i·K, and surface roughness (RMS surface roughness) o. As the preferable material for the metal film, a material of which both of the real part n and the imaginary part κ (corresponding to the absorption coefficient) of the complex refractive index are small is preferable. As specific examples of such a material, Au, Ag, Cu, Mg, Al, Ni, Pd, and the like can be given. If the thickness d is small, since light passes through the metal film, the reflectance decreases.

It is preferable that the thickness of the metal film be 30 nm or more, although the thickness varies depending on the value of the imaginary part κ of the complex refractive index of the metal used.

If the surface roughness σ is great, light undergoes diffused reflection so that the amount of components reflected in the direction perpendicular to the emission surface of the organic EL device decreases. Therefore, the surface roughness σ is preferably less than 10 nm, and still more preferably less than 5 nm.

A dielectric multilayer film may also be used. The dielectric multilayer film is formed of a stacked body including a high-refractive-index dielectric layer (refractive index: $n_H$, thickness $d_H$) and a low-refractive-index dielectric layer (refractive index: $n_L$, thickness $d_L$). The thickness of each layer is set so that the following equation is satisfied with respect to the wavelength λ of light.

$$n_H \times d_H = n_L \times d_L = \lambda / 4$$

As specific examples of the dielectric material having a high refractive index, metal oxides such as $Al_2O_3$ MgO, $Nd_2O_3$, $GdO_3$, $ThO_2$, $Y_2O_3$, $Sc_2O_3$, $La_2O_3$, $ZrO_2$, $Ta_2O_5$, ZnO, $CEaO_2$, $TiO_2$, and PbO, and metal chalcogenides such as ZnS, CdS, ZnSe, and ZnTe, and the like can be given. As specific examples of the dielectric material having a low refractive index, silicon oxides such as $SiO_2$ and $Si_2O_3$, metal fluorides such as NaF, LiF, $CaF_2$, $Na_3AlF_6$, $AlF_3$, and $MgF_2$, and the like can be given.

As the refractive index ratio "$n_L/n_H$" decreases, the wavelength range in which the reflectance becomes higher increases. In order to increase the reflectance in the range of 450 to 650 nm within which the visibility of visible light is relatively high, it is preferable that the ratio "$n_L/n_H$" be less than 0. 6. As examples of the combination of such materials, a combination of $TiO_2$ (n=2.5) and $MgF_2$ (n=1.39) can be given.

It is preferable that the first reflecting section have a reflectance of 65% or more for the light emitted from the color conversion member. This allows the reflectance of the device to be easily set at 50% or more, even if a member which absorbs light is used as the member forming the emitting device. The reflectance is particularly preferably 70% or more.

(3) First to third transparent layers

As the material for the transparent layer, a material having a transmittance of 50% or more in the visible wavelength region (380 to 780 nm) and exhibiting any of charge injecting properties, conductivity, and semi-conductivity may be used without specific limitations.
As specific examples of such a material, (a) conductive radical salt, (b) a material including an acceptor component which is a conductive oxide containing a transition metal and a donor component which is an alkali metal and/or alkaline earth metal, (c) a chalcogenide and a combination of a chalcogenide and an alkali metal, and (d) an inorganic oxide can be given.
As examples of the conductive organic radical salt (a), compounds shown by the following formula can be given.

$$D_yA_z$$

wherein D represents a donor molecule or atom, A represents an acceptor molecule or atom, y represents an integer from 1 to 5, and z represents an integer from 1 to 5.
As the molecule or atom represented by D, alkali metals such as Li, K, Na, Rb, and Cs, alkaline earth metals such as Ca, La, $NH_4$, and the like are preferable.
As the acceptor molecule or atom represented by A, $TaF_6$, $AsF_6$, $PF_6$, $ReO_4$, $C10_4$, $BF_4$, Au $(CN)_2$, Ni $(CN)_4$, $CoCl_4$, CoBr, $I_3$, $I_2Br$, $IBr_2$, $AuI_2$, $AuBr_2$, $Cu_5I_6$, $CUCl_4$, $Cu(NCS)_2$, $FeCl_4$, $FeBr_4$, $MnCl_4$, $KHg(SCN)_4$, $Hg(SCN)_3$, $NH_4(SCN)_4$, and the like are preferable.
As the acceptor component of the material (b) including the acceptor component which is a conductive oxide containing a transition metal and the donor component which is an alkali metal and/or alkaline earth metal, at least one oxide selected from the group consisting of $Li_xTi_2O_4$, $Li_xV_2O_4$, $Er_xNbO_3$, $La_xTiO_3$, $Sr_xVO_3$, $Ca_xCrO_3$, $Sr_xCrO_3$, $A_xMoO_3$, and $AV_2O_5$ (A=K, Cs, Rb, Sr, Na, Li, or Ca) (x=0.2 to 5) is preferable.
As the alkali metal and the alkaline earth metal, those given above for D are preferable.
As the chalcogenide (c), ZnSe, ZnS, TaS, TaSe, ZnO, and the like are preferable. It is also preferable to use a compound formed of a chalcogenide and an alkali metal. For example, LiZnSe, LiZnSi, LiZnO, LiInO, and the like are preferable.
As the inorganic oxide (d), oxides of In, Sn, Zn, Ce, Sm, Pr, Nd, Tb, Cd, Ga, Al, Mo, W, and the like can be given. An oxide containing In, Sn, or Zn is preferable.
From the viewpoint of properties of injecting charges into the organic emitting layer and low resistance, it is particularly preferable to use indium tin oxide (ITO), indium cerium oxide (ICO), indium zinc oxide (IZO), copper indium (CuIn), tin oxide ($SnO_2$), zinc oxide (ZnO), antimony oxide ($Sb_2O_3$, $Sb_2O_4$, $Sb_2O_5$), or aluminum oxide ($Al_2O_3$), either individually or in combination of two or more.
The thicknesses of the first and third transparent layers are set in the range of 5 to 1000 nm, and preferably 10 to 500 nm so that the organic EL device has a reflectance of 50% or more for the peak wavelength of light emitted from the color conversion member.

(4) Second reflecting section

As the material for the second reflecting section, it is preferable to use a metal which reflects and transmits light emitted from the organic emitting layer and can form an optical resonator with the first reflecting section. As examples of such a metal, metals such as Ag, Mg, Al, Au, Pt, Cu, Cr, Mo, W, Ta, Nb, Li, Mn, Ca, Yb, Ti, Ir, Be, Hf, Eu, Sr, Ba, Cs, Na, and K, and an alloy of these metals can be given.
When using the metal layer as a cathode contacting the organic emitting layer, Al, Ag, Mg, Ce, Ce, Na, K, Cs, and Li, and an alloy of these metals are preferable due to a small work function (e.g. 4.0 eV or less). The thickness of the second reflecting section is preferably 2 to 100 nm. If the thickness is less than 2 nm, the electron-injecting properties are decreased when used as a cathode, whereby the luminous efficiency of the device may be decreased, or a sufficient optical resonator effect cannot be obtained due to high transmittance. In addition, the organic emitting layer positioned under the second reflecting section may be damaged when forming the second transparent layer by sputtering or the like. If the thickness of the second reflecting section is larger than 100 nm, the light-outcoupling efficiency may be decreased due to a decrease in transmittance.

(5) Gas barrier layer

It is preferable to provide the gas barrier layer so that the organic emitting layer is covered with the gas barrier

layer in order to prevent moisture or oxygen from entering the organic emitting layer. The gas barrier layer is usually formed using a transparent insulator. The gas barrier layer preferably has a configuration in which a desiccating agent, dry gas, or inert liquid such as a fluorinated hydrocarbon is enclosed therein. The gas barrier layer is preferably an inorganic oxide layer, an inorganic nitride layer, or a layer of nitride of an inorganic acid insofar as the material exhibits excellent dampproof properties. As examples of such a material, silica, alumina, ALON, SiAlON, $SiN_x$, and the like can be given.

The formation method for each layer of the organic EL device is not particularly limited. Each layer of the organic EL device may be formed by a known sputtering method, vacuum deposition method, or molecular beam epitaxy (MBE) method, or a coating method using a solvent solution, such as a dipping method, spin coating method, casting method, bar coating method, or roll coating method.

3. Color conversion member

(1) Color conversion member

The color conversion member used in the invention has the function of absorbing light emitted from the emitting device and emitting light having a longer wavelength. The light emitted from the color conversion member is fluorescence or phosphorescence which occurs upon excitation by light from a light source.

The color conversion member is formed of either a fluorescent material or a combination of a fluorescent material and a transparent medium, for example. The color conversion member may be combined with the color filter described later in order to prevent a decrease in contrast due to external light.

As the fluorescent material, an organic fluorescent dye, an organic fluorescent pigment, a metal complex dye, an inorganic fluorescent material, or the like may be used. As the transparent medium, an inorganic transparent material such as glass, or a transparent resin such as a thermoplastic resin, a heat-curable resin, or a photocurable resin may be used.

When forming the color conversion member using an organic fluorescent dye and a resin, a single organic fluorescent dye or two or more types of organic fluorescent dye may be used depending on the desired emission color. When converting blue to blue green exciting light into red light, it is preferable to use a rhodamine dye having a fluorescence peak in a wavelength region of 600 nm or more. It is still more preferable to use a fluorescent dye having an absorption band in the wavelength region of the exciting light and inducing energy transfer or resorption to the rhodamine dye.

The content of the organic fluorescent dye in the color conversion member resin composition is preferably 0.01 to 1 wt%. If the content of the organic fluorescent dye is less than 0.01 wt%, the color conversion member cannot sufficiently absorb the exciting light, whereby the fluorescence intensity may decrease. If the content of the organic fluorescent dye is larger than 1 wt%, the distance between the organic fluorescent dye molecules is too reduced in the color conversion member, whereby the fluorescence intensity may decrease due to concentration quenching.

Preferable fluorescent dyes are given below for each combination of the color of exciting light emitted from the emitting device and the emission color.

As examples of fluorescent dye which converts near ultraviolet to bluish violet exciting light into blue light, stilbene dye such as 1,4-bis(2-methylstyryl)benzene and trans-4,4-diphenylstilbene, and coumarin dye such as 7-hydroxy-4-methylcoumarin (also called "coumarin 4") can be given.

As examples of a fluorescent dye which converts blue, blue green, or white exciting light into green light, coumarin dye such as 2,3,5,6-1H, 4H-tetrahydro-8-trifluoromethylquinolizine(9, 9a, 1-gh)coumarin (also called "coumarin 153"), 3-(2'-benzothiazolyl)-7-diethylaminocoumarin (also called "coumarin 6"), 3-(2'-benzimidazolyl)-7-N,N-diethylaminocoumarin (also called "coumarin 7"), and naphthalimido dye such as basic yellow 51, solvent yellow 11, and solvent yellow 116 can be given.

As examples of a fluorescent dye which converts blue, green, or white exciting light into orange to red light, cyanine dye such as 4-dicyanamethylene-2-methyl-6-(p-dimethylaminastyryl)-4H-pyrane, pyridine dye such as 1-ethyl-2-[4-(p-dimethylaminophenyl)-1,3-butadienyl]-pyridinium-perchlorate, and rhodamine dye such as rhodamine B, rhodamine 6G, rhodamine 3B, rhodamine 101, rhodamine 110, basic violet 11, and sulforhodamine 101 can be given.

A rhodamine dye containing in the molecule at least one steric hindrance group which prevents formation of an aggregate may also be used. Examples of such a rhodamine dye are disclosed in JP-A-11-279426.

As the inorganic fluorescent material, an inorganic compound such as a metal compound which absorbs visible light and emits fluorescence longer than the absorbed light, may be used. The surface of the fine particle may be modified with an organic substance such as a long-chain alkyl group or phosphoric acid in order to increase the dispersibility in the matrix resin described later, when a dispersion wherein the inorganic fluorescent material made into fine particles is dispersed in a transparent resin is used as the color conversion member.

Specific examples of the particles are given below.

(a) Metal compounds produced by doping transition metal ion to metal oxide

Metal compounds produced by doping a transition metal ion such as $Eu^{2+}$, $Eu^{3+}$, $Ce^{3+}$, or $Tb^{3+}$ to a metal oxide such as $Y_2O_3$, $Gd_2O_3$, ZnO, $Y_3Al_5O_{12}$, or $Zn_2SiO_4$, may be used

(b) Metal compounds produced by doping transition metal ion to metal chalcogenide

Metal compounds produced by doping a transition metal ion which absorbs visible light, such as $Eu^{2+}$, $Eu^{3+}$, $C_e{}^{3+}$, or ${}_{Tb}{}^{3+}$ to a metal chalcogenide such as ZnS, CdS, or CdSe, may be used. In order to prevent S, Se, or the like from being removed by a reaction component of the matrix resin described later, the surface of the metal compound may be modified with a metal oxide such as silica or an organic substance, for example.

(c) Fine particles absorbing and emitting visible light utilizing band gap of semiconductor

Semiconductor fine particles such as CdS, CdSe, CdTe, ZnS, ZnSe, and InP may be used. As known from the literature such as JP-A-2002-510866, the band gap of these particles can be controlled by making the particle size to a nano level, so that the absorption/fluorescence wavelength can be changed. In order to prevent S, Se, or the like from being removed by a reaction component of the matrix resin described later, the surface of the particle may be modified with a metal oxide such as silica or an organic substance, for example.

For example, the surface of the CdSe fine particle may be covered with a shell of a semiconductor material (e.g. ZnS) having a higher band gap energy. This allows the confinement effect of electrons generated in the core particle to easily exhibit.
The above-mentioned fine particles may be used either individually or in combination of two or more.

When forming the color conversion member using the fluorescent material and the resin, the organic fluorescent dye, the resin, and a suitable solvent are mixed, dispersed, or dissolved to prepare a liquid. The liquid is applied by a spin coating method, a roll coating method, a casting method, or the like. The resulting film is patterned into a desired color conversion member pattern by a photolithographic method. Or, a color conversion member is patterned into a desired pattern by a screen printing method or the like.

The thickness of the color conversion member is not particularly limited insofar as the color conversion member sufficiently absorbs light emitted from the organic EL device and generation of fluorescence is not hindered. The thickness of the color conversion member is preferably 10 nm to 1 mm, more preferably 0,5 μm to 1 mm, and still more preferably 1 to 100 μm,

As the transparent resin (binder resin) for dispersing the fluorescent material, a non-curable resin or a photocurable resin may be used. The transparent resin may be used either individually or in combination of two or more. In a full color display, the color conversion members are separately disposed in a matrix. Therefore, it is preferable to use a photosensitive resin, which allows application of a photolithographic method, as the transparent resin. The photosensitive resin and the non-curable resin used as the resin are described below.

As the photosensitive resin, a photosensitive resin (photocurable resist material) containing a reactive vinyl group such as an acrylic resin, methacrylic resin, polyvinyl cinnamate resin, or hard rubber resin, or a mixture of these resins is preferable.
Such a photosensitive resin includes a reactive oligomer, an initiator, a polymerization promoter, and monomers as a reactive diluent.

As examples of the reactive oligomer suitably used in the invention, an epoxy acrylate obtained by adding acrylic acid to a biphenol type epoxy resin or a novolak type epoxy resin; a polyurethane acrylate obtained by reacting a polyfunctional isocyanate with equimolar amounts of 2-hydroxyethyl acrylate and a polyhydric alcohol at an arbitrary molar ratio; a polyester acrylate obtained by reacting a polyhydric alcohol with equimolar amounts of acrylic acid and a polycarboxylic acid at an arbitrary molar ratio; a polyether acrylate obtained by reacting a polyol with acrylic acid; a reactive polyacrylate obtained by reacting acrylic acid with an epoxy group on the side chain of poly(methyl methacrylate-CO-glycidyl methacrylate) or the like; a carboxyl-modified epoxy acrylate obtained by modifying a part of an epoxy acrylate with a dibasic carboxylic anhydride; a carboxyl-modified reactive polyacrylate obtained by modifying a part of a reactive polyacrylate with a dibasic carboxylic anhydride; a polybutadiene acrylate containing an acrylate group on the side chain of a polybutadiene oligomer; a silicon acrylate containing a polysiloxane bond on the main chain; and an amyloplast resin acrylate obtained by modifying an amyloplast resin can be given.

As the initiator for the photosensitive resin, an initiator generally used for polymerization may be used without specific limitations. As examples of the initiator, a vinyl monomer, benzophenone, acetophenone, benzoin, thioxanthone, anthraquinone, azobisisobutyronitrile, and an organic peroxide such as benzoyl peroxide can be given. As the suitable

polymerization promoter for the photosensitive resin, triethanolamine, 4,4'-dimethylaminobenzophenone (Michler's ketone), ethyl 4-dimethylaminobenzoate, and the like can be given.

As examples of the monomer used as the reactive diluent for the photosensitive resin, radically polymerizable monomers such as monofunctional monomers such as acrylate and methacrylate; polyfunctional monomers such as trimethylolpropane triacrylate, pentaerythritol triacrylate, dipentaerythritol hexaacrylate, polyester acrylate, epoxy acrylate, urethane acrylate, polyether acrylate, and the like can be given.

As the non-curable resin, a polymethacrylate, polyvinyl chloride, vinyl chloride-vinyl acetate copolymer, alkyd resin, aromatic sulfonamide resin, urea resin, melamine resin, benzoguanamine resin, and the like are preferable. Of these non-curable resins, a benzoguanamine resin, melamine resin, and vinyl chloride resin are particularly preferable. The binder resin may be used either individually or in combination of two or more.

A diluent binder resin may also be used in addition to the non-curable resin. As examples of such a resin, polymethyl methacrylate, polyacrylate, polycarbonate, polyester, polyvinyl alcohol, polyvinylpyrrolidone, hydroxyethylcellulose, carboxymethylcellulose, polyamide, silicone, or epoxy resin, or a mixture of these resins can be given.

(2) Color filter

Examples of materials for the color filter used in the invention include dyes or solid objects in which the same dye is dissolved or dispersed in a binder resin.

| | |
|---|---|
| Red dye (R) : | perylene pigment, lake pigment, azo pigment and the like |
| Green dye (G): | halogen-multisubstituted phthalocyanine pigment, halogen-multisubstituted copper phthalocyanine pigment, basic triphenylmethane dye and the like |
| Blue dye (B) : | copper phthalocyanine pigment, indanthrone pigment, indophenol pigment, cyanine pigment and the like. |

On the other hand, material for the binder resin is transparent (transmittance of visible light: 50% or more). Examples of the binder resin include transparent resins (polymers) such as polymethyl methacrylate, polyacrylate, polycarbonate, polyvinyl alcohol, polyvinyl pyrrolidone, hydroxyethylcellulose, and carboxymethylcellulose, and photosetting resist materials having reactive vinyl groups such as acrylic acid type, methacrylic acid type, and the like, as photosensitive resins to which photo lithography can be applied.
When employing printing method, a print ink (medium) including a transparent resin such as polyvinyl chloride resin, melamine resin, or phenol resin may be selected.

When forming the color filter using a dye as the major component, the color filter may be formed by a vacuum deposition method or a sputtering method using a mask having a desired color filter pattern.
When forming the color filter using a dye and a binder resin, the dye, the above-described resin and a resist are mixed, dispersed, or dissolved to prepare a liquid. The liquid is applied by a spin coating method, a roll coating method, a casting method, or the like. The resulting film is patterned into a desired color filter pattern by a photolithographic method. Or, a color filter is patterned into a desired color filter pattern by a printing method or the like.

The thickness and the transmittance of each color filter are preferably set as follows.
R: thickness: 0.5 to 5.0 μm (transmittance: 50% or more at 610 nm)
G: thickness: 0.5 to 5.0 μm (transmittance: 50% or more at 545 nm)
B: thickness: 0.2 to 5.0 μm (transmittance: 50% or more at 460 nm)
In the invention, when providing a full color emitting device which emits light of red, green, and blue (three primary colors), a black matrix may be used to increase the contrast ratio.

EXAMPLES

The invention is described below in more detail by way of examples.

Example 1

1. Fabrication of organic EL device substrate

Aluminum was deposited on a supporting substrate (75×25×1.1 mm) (0A2 glass manufactured by Nippon Electric Glass Co. , Ltd.) by sputtering to a thickness of 300 nm. The aluminum film functions as a lower electrode and a first reflecting section.

ITO was deposited on the aluminum film by sputtering to a thickness of 130 nm. The ITO film functions as an electrode for injecting holes into an organic emitting layer, and also functions as a first transparent layer.

The substrate on which the lower electrode was formed was subjected to ultrasonic cleaning for five minutes in isopropyls alcohol, and then subjected to UV ozone cleaning for 30 minutes. The cleaned substrate was installed in a substrate holder of a vacuum deposition system.

A molybdenum heating boat was respectively charged in advance with a compound (HI) (hereinafter abbreviated as "HI film") as a hole-injecting material, a compound (HT) (hereinafter abbreviated as "HT film") as a hole-transporting material, a compound (BH) as a host of an emitting material, a compound (BD) as a blue emitting dopant, tris(8-quinolinol) aluminum (Alq) as an electron-transporting material, LiF as an electron-injecting material, and Mg and Ag as a cathode material. An IZO target was placed in another sputtering chamber as a hole-injecting assist material and a cathode extraction electrode.

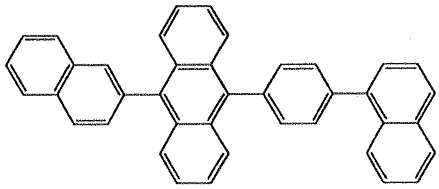

BH

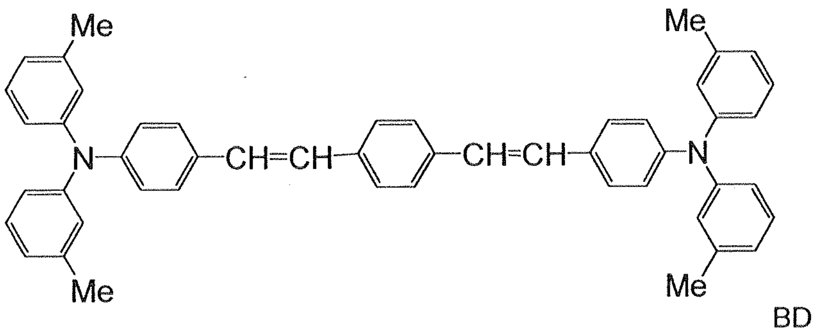

BD

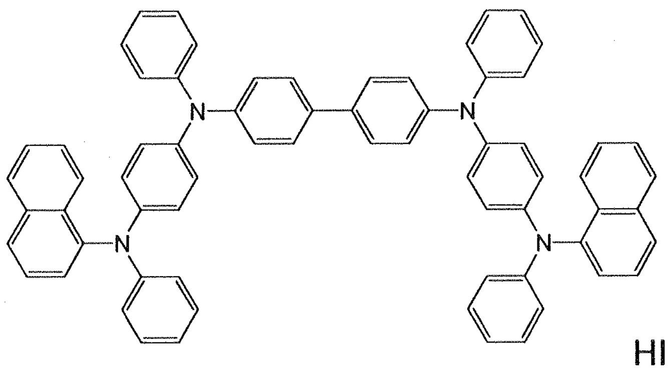

HI

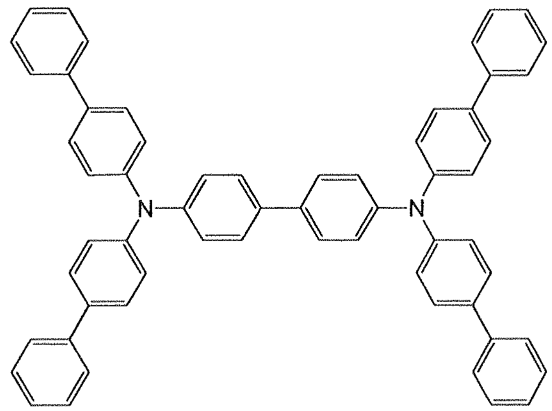

HT

The HI film functioning as the hole-injecting layer was deposited to a thickness of 20 nm. The HT film functioning as the hole-transporting layer was then deposited to a thickness of 15 nm. As the blue emitting layer, the compound BH and the compound BD were co-deposited in the weight ratio of 30:1.5 to a thickness of 30 nm.
The Alq film as the electron-transporting layer was deposited on the resulting film to a thickness of 10 nm. Then, LiF was deposited as the electron-injecting layer to a thickness of 1 nm, and Ag and Mg were deposited on the LiF film to a thickness of 10 nm at a deposition rate ratio of 1: 9. The Ag-Mg film functions as an electrode for injecting electrons into the organic emitting layer, and also functions as a second reflecting section.
Then, IZO was deposited by sputtering to a thickness of 90 nm. The IZO film functions as an upper electrode and a second transparent layer.
As the gas barrier layer, a transparent inorganic film $SiO_xN_y$ (O/O+N=50%: atomic ratio) was deposited on the upper electrode by low-temperature CVD to a thickness of 1000 nm so that the entire organic EL emitting section was covered.
An organic EL device was thus obtained.

2. Fabrication of color conversion substrate

(1) Fabrication of color filter

A red pigment color filter material ("CRY-S840B" manufactured by FUJIFILM Electronic Materials Co., Ltd.) was applied by spin coating to a supporting substrate (40×25×1.1 mm) (0A2 glass manufactured by Nippon Electric Glass Co. , Ltd.) smaller than that for the organic EL device, and was exposed to ultraviolet rays in a predetermined pattern. The resulting product was baked at 200°C to obtain a red color filter layer (thickness: 1.2 μm) substrate.

(2) Fabrication of color conversion member

A methacrylic acid-methyl methacrylate copolymer (methacrylic acid copolymerization ratio: 15 to 20%, Mw: 20, 000 to 25,000) was used as a matrix resin. After dissolving the matrix resin in 1-methoxy-2-acetoxypropane, CdSe fine particles (fluorescence wavelength: 606 nm) having a particle size of 5.1 nm were added to the mixture. The CdSe particles were added so that the weight ratio of the CdSe particles to the total solid content was 17.8 wt%.
The mixture was coated on the color filter film of the red color filter substrate by spin coating, and dried at 200°C for 30 minutes to obtain a color conversion substrate in which the red color filter and the red conversion member were stacked. The thickness of the color conversion member was 17 μm.

3. Attachment of organic EL device substrate and color conversion substrate

Liquid silicone rubber ("XE14-128" manufactured by GE Toshiba Silicones) was applied to the color conversion substrate using a spin coater, and the organic EL device substrate was attached to the color conversion substrate through the silicone rubber. A color emitting device, in which the area in which the color conversion member was not provided was a blue pixel and the area in which the color conversion member was provided was a red pixel, was obtained in this manner.

4. Evaluation of color emitting device

(1) Fluorescence peak wavelength of color conversion substrate

Monochromatic exciting light having a wavelength of 470 nm was irradiated to the color conversion substrate from the surface of color conversion member at an angle of 45°, and the fluorescence spectrum emitted from the color conversion member was measured using a fluorescence meter. As a result, the peak wavelength was 606 nm.

(2) Reflectance of organic EL device and optical thickness of member

The reflectance of the organic EL device for light perpendicularly incident on the surface of the organic EL device on which the color conversion member was not provided was measured using a microspectroscopic reflectometer. The reflectance for the peak wavelength (606 nm) of fluorescence emitted from the color conversion member was 71.8%.

The optical lengths of the first transparent layer (ITO film, thickness: 130 nm) and the second transparent member (IZO film, thickness: 90 nm) at 606 nm were measured using a thickness/refractive index measurement device (manufactured by SCI). As a result, the optical lengths of the first transparent layer and the second transparent member were respectively 238 nm and 165 nm.

The substrate on which LiF was deposited was removed during the fabrication of the organic EL device, and the optical length of the entire organic emitting layer (HI film: 20 nm, HT film: 15 nm, BH:BD film: 30 nm, Alq film: 10 nm, LiF film: 1 nm) was measured. As a result, the optical length was 130 nm. Specifically, the optical length between the first reflecting section and the second reflecting section was 368 nm (= 238 nm + 130 nm).

(3) Luminous performance of color emitting device

The applied voltage was adjusted so that light emitted from the portion (blue pixel) of the organic EL device in which the color conversion member was not provided was 1000 nit, and the luminous characteristics of the portion (red pixel) in which the color conversion member was provided were measured using a spectroradiometer. As a result, the red pixel exhibited excellent red emission with a luminance of 787 nit and a chromaticity of (0.634, 0.361).

Comparative Example 1

A color emitting device was obtained in the same manner as in Example 1 except for forming an ITO film with a thickness of 10 nm as the first transparent layer and an IZO film with a thickness of 45 nm as the second transparent layer. The characteristics of the color emitting device were evaluated in the same manner as in Example 1 to obtain the following results.

(1) Fluorescence wavelength of color conversion substrate

Monochromatic exciting light having a wavelength of 470 nm was irradiated to the color conversion substrate from the surface of color conversion member at an angle of 45°, and the fluorescence spectrum from the color conversion member was measured using a fluorescence meter. As a result, the peak wavelength was 606 nm.

(2) Reflectance of organic EL device and optical thickness of member

The reflectance of the organic EL device for light perpendicularly incident on the surface of the organic EL device on which the color conversion member was not provided was measured using a microspectroscopic reflectometer. The reflectance for the peak wavelength (606 nm) of fluorescence emitted from the color conversion member was 41.9%. The optical lengths of the first transparent layer (ITO film, thickness: 10 nm) and the second transparent layer (IZO film, thickness: 45 nm) at 606 nm were measured using a thickness/refractive index measurement device (manufactured by SCI). As a result, the optical lengths of the first transparent layer and the second transparent layer were 19 nm and 91 nm, respectively.

(3) Luminous performance of color emitting device

The applied voltage was adjusted so that light emitted from the portion of the organic EL device in which the color conversion member was not provided was 1000 nit, and the luminous characteristics of the portion in which the color conversion member was provided was measured using a spectroradiometer. As a result, the luminance was 415 nit and the chromaticity of (0.630, 0.366). Specifically, the luminance was approximately half that of Example 1.

Comparative Example 2

A color emitting device was obtained in the same manner as in Example 1 except for using Cr for the first reflecting section instead of Al. The characteristics of the color emitting device were evaluated in the same manner as in Example 1 to obtain the following results.

(1) Fluorescence wavelength of color conversion substrate

Monochromatic exciting light having a wavelength of 470 nm was irradiated to the color conversion substrate from the surface of color conversion member at an angle of 45°, and the fluorescence spectrum from the color conversion member was measured using a fluorescence meter. As a result, the peak wavelength was 606 nm.

(2) Reflectance of organic EL device and optical thickness of member

The reflectance of the organic EL device for light perpendicularly incident on the surface of the organic EL device on which the color conversion member was not provided was measured using a microspectroscopic reflectometer. The reflectance for the peak wavelength (606 nm) of fluorescence emitted from the color conversion member was 25.8%. The optical lengths of the first transparent member (ITO film, thickness: 130 nm) and the second transparent member (IZO film, thickness: 90 nm) at 606 nm were measured using a thickness/refractive index measurement device (manufactured by SCI). As a result, the optical lengths of the first transparent member and the second transparent member were respectively 238 nm and 165 nm.

(3) Luminous performance of color emitting device

The applied voltage was adjusted so that light emitted from the portion of the organic EL device in which the color conversion member was not provided was 1000 nit, and the luminous characteristics of the portion in which the color conversion member was provided was measured using a spectroradiometer. As a result, the luminance was 339 nit and the chromaticity of (0.627, 0.368). Specifically, the luminance was less than half that of Example 1.

INDUSTRIAL APPLICABILITY

The color emitting device according to the invention can be used for various displays such as TVs, large-screen displays, and displays for portable telephones.

## Claims

**1.** A color emitting device comprising an emitting device and a color conversion member which absorbs light emitted from the emitting device and emits light; the emitting device including at least a first reflecting section and a second reflecting section provided in that order in a light-outcoupling direction, and an organic emitting layer positioned between the first and second reflecting sections; the color conversion member being positioned on a light-outcoupling side of the second reflecting section; and the emitting device having a reflectance of 50% or more for a peak wavelength of the light emitted from the color conversion member.

**2.** The color emitting device according to claim 1,
wherein the emitting device further includes a first transparent layer and a second transparent layer in that order in the light-outcoupling direction;
wherein the first transparent layer is positioned between the first and second reflecting sections; and
wherein the color conversion member is positioned on the light-outcoupling side of the second transparent layer.

**3.** The color emitting device according to claim 2, wherein the second transparent layer is positioned between the second reflecting section and the color conversion member.

**4.** A color emitting device comprising:

a first pixel including a first emitting device and a first color filter in that order in a light-outcoupling direction, the first color filter transmitting light of a first color emitted from the first emitting device;
a second pixel including a second emitting device and a second color filter in that order in the light-outcoupling

direction, the second color filter transmitting light of a second color emitted from the second emitting device; and
a third pixel including a third emitting device and a color conversion member in that order in the light-outcoupling direction, the color conversion member absorbing light emitted from the third emitting device and emitting light of a third color;
the first emitting device including at least a first reflecting section, an organic emitting layer, a second reflecting section, and a second transparent layer in that order in the light-outcoupling direction;
the second emitting device including at least the first reflecting section, a third transparent layer, the organic emitting layer, the second reflecting section, and the second transparent layer in that order in the light-outcoupling direction;
the third emitting device including at least the first reflecting section, a first transparent layer, the organic emitting layer, the second reflecting section, and the second transparent layer in that order in the light-outcoupling direction, the third emitting device having a reflectance of 50% or more for the light of the third color emitted from the color conversion member; and
the organic emitting layer including at least a first emitting material which emits the light of the first color and a second emitting material which emits the light of the second color.

**5.** The color emitting device according to claim 4, wherein the third emitting device further includes a third color filter which transmits the light of the third color.

**6.** A color emitting device comprising:

a first pixel including a first emitting device and a first color filter in that order in a light-outcoupling direction, the first color filter transmitting light of a first color emitted from the first emitting device;
a second pixel including a second emitting device and a color conversion member in that order in the light-outcoupling direction, the color conversion member absorbing light emitted from the second emitting device and emitting light of a second color; and
a third pixel including a third emitting device and a color conversion member in that order in the light-outcoupling direction, the color conversion member absorbing light emitted from the third emitting device and emitting light of a third color;
the first emitting device including at least a first reflecting section, an organic emitting layer, a second reflecting section, and a second transparent layer in that order in the light-outcoupling direction;
the second emitting device including at least the first reflecting section, a first transparent layer, the organic emitting layer, the second reflecting section, and the second transparent layer in that order in the light-outcoupling direction, the second emitting device having a reflectance of 50% or more for the light of the second color emitted from the color conversion member;
the third emitting device including at least the first reflecting section, the first transparent layer, the organic emitting layer, the second reflecting section, and the second transparent layer in that order in the light-outcoupling direction, the third emitting device having a reflectance of 50% or more for the light of the third color emitted from the color conversion member; and
the organic emitting layer including at least a first emitting material which emits the light of the first color.

**7.** The color emitting device according to claim 6, wherein the second emitting device includes a second color filter which transmits the light of the second color, and the third emitting device includes a third color filter which transmits the light of the third color.

**8.** The color emitting device according to any one of claims 2 to 7, wherein a sum "S1+S2" of a product S1 of a thickness of the first transparent layer and a refractive index of the first transparent layer for the light of the color emitted from the color conversion member and a product S2 of a thickness of the organic emitting layer and a refractive index of the organic emitting layer for the light of the color emitted from the color conversion member is 250 to 500 nm.

**9.** The color emitting device according to claim 8, wherein the product of the thickness of the first transparent layer and the refractive index of the first transparent layer for the light of the color emitted from the color conversion member is 100 to 350 nm.

**10.** The color emitting device according to claim 8, wherein a product of a thickness of the second transparent layer and a refractive index of the second transparent layer for the light of the color emitted from the color conversion member is 100 to 300 nm.

**11.** The color emitting device according to any one of claims 1 to 3, wherein the light emitted from the organic emitting layer is repeatedly reflected between the first and second reflecting sections so that light having an absorption wavelength of the color conversion member is selectively enhanced.

**12.** The color emitting device according to claim 4 or 5,
wherein, in the first emitting device, the light emitted from the organic emitting layer is repeatedly reflected between the first and second reflecting sections so that the light of the first color is selectively enhanced;
wherein, in the second emitting device, the light emitted from the organic emitting layer is repeatedly reflected between the first and second reflecting sections so that the light of the second color is selectively enhanced; and
wherein, in the third emitting device, the light emitted from the organic emitting layer is repeatedly reflected between the first and second reflecting sections so that light having an absorption wavelength of the color conversion member is selectively enhanced.

**13.** The color emitting device according to claim 6 or 7,
wherein, in the first emitting device, the light emitted from the organic emitting layer is repeatedly reflected between the first and second reflecting sections so that the light of the first color is selectively enhanced;
wherein, in the second emitting device, the light emitted from the organic emitting layer is repeatedly reflected between the first and second reflecting sections so that light having an absorption wavelength of the color conversion member is selectively enhanced; and
wherein, in the third emitting device, the light emitted from the organic emitting layer is repeatedly reflected between the first and second reflecting sections so that light having an absorption wavelength of the color conversion member is selectively enhanced.

**14.** The color emitting device according to claim 1, 4, or 6,
wherein the first reflecting section has a reflectance of 65% or more for the light emitted from the color conversion member.

FIG. 1

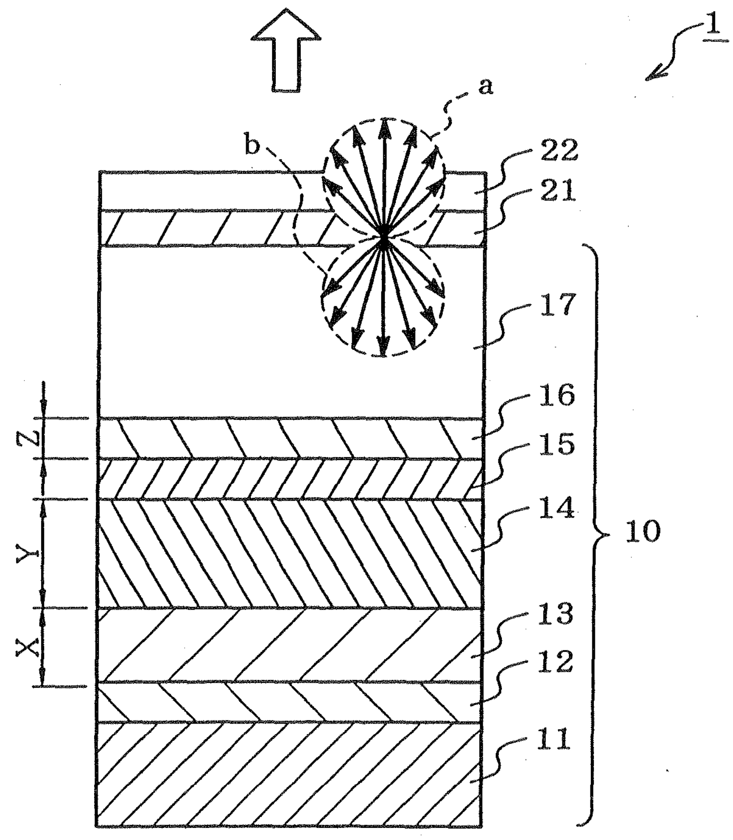
1
a
b
22
21
17
16
15
14
13
12
11
10
Z
Y
X

FIG. 2

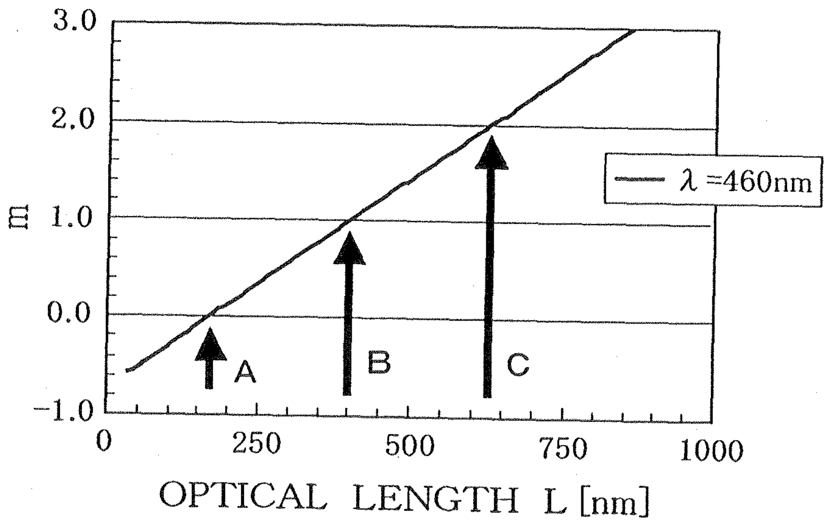
3.0
2.0
1.0
0.0
−1.0
m
0
250
500
750
1000
OPTICAL LENGTH L [nm]
λ =460nm
A
B
C

FIG. 3

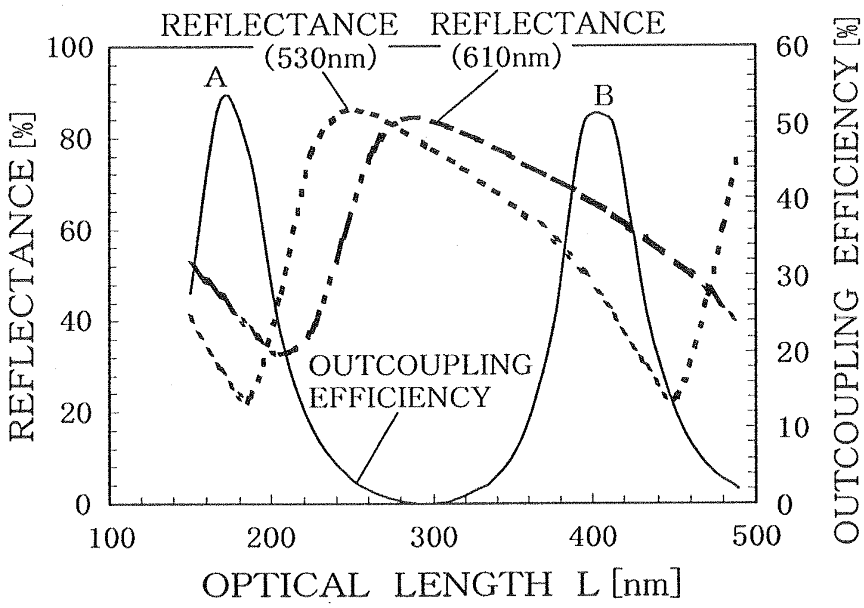
REFLECTANCE (530nm)
REFLECTANCE (610nm)
A
B
OUTCOUPLING EFFICIENCY
REFLECTANCE [%]
OUTCOUPLING EFFICIENCY [%]
OPTICAL LENGTH L [nm]
100
80
60
40
20
0
60
50
40
30
20
10
0
100
200
300
400
500

FIG. 4

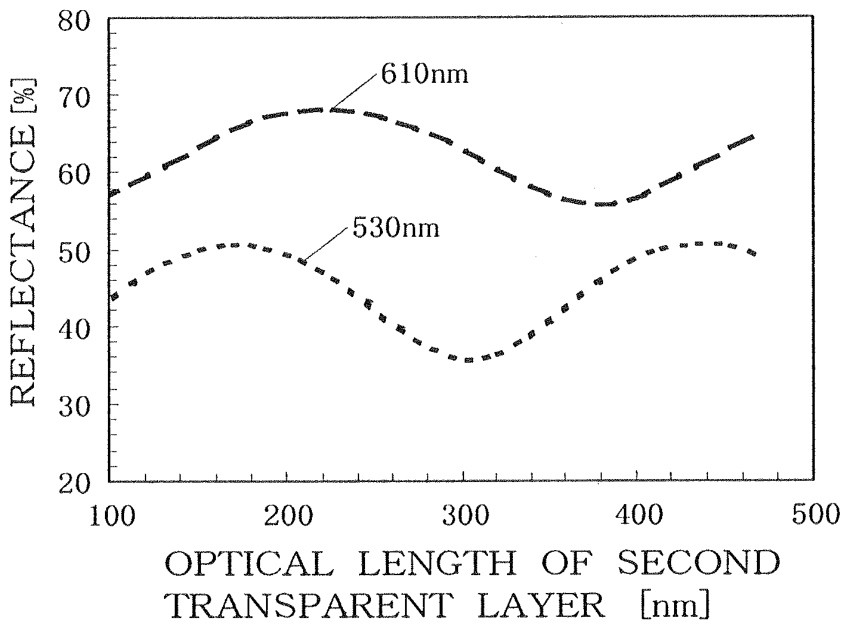
610nm
530nm
REFLECTANCE [%]
OPTICAL LENGTH OF SECOND TRANSPARENT LAYER [nm]
80
70
60
50
40
30
20
100
200
300
400
500

FIG. 5

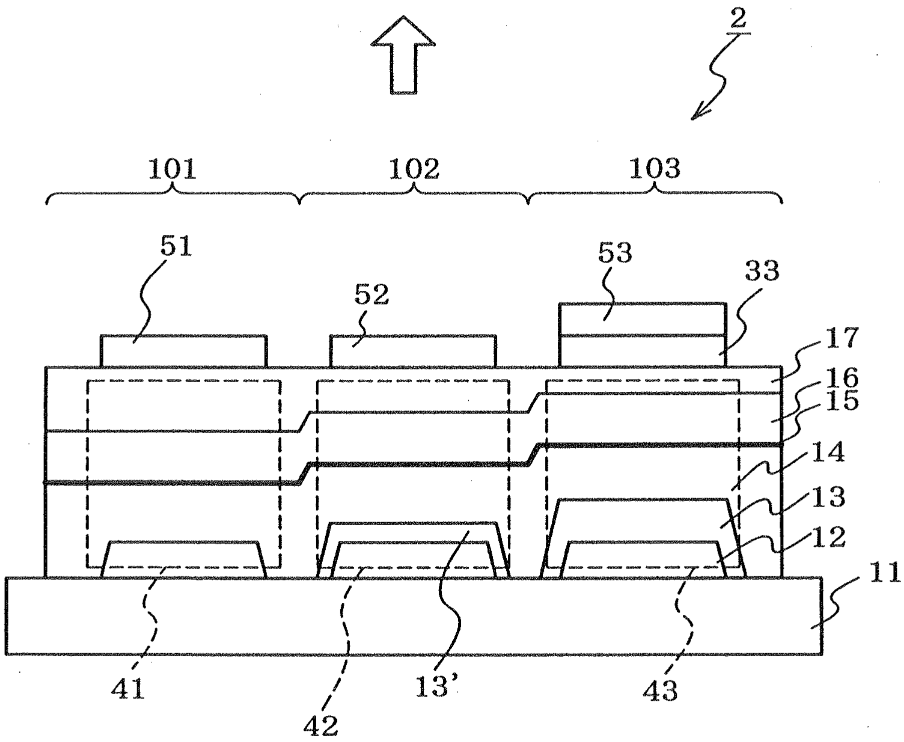
2
101
102
103
51
52
53
33
17
16
15
14
13
12
11
41
42
13'
43

FIG. 6

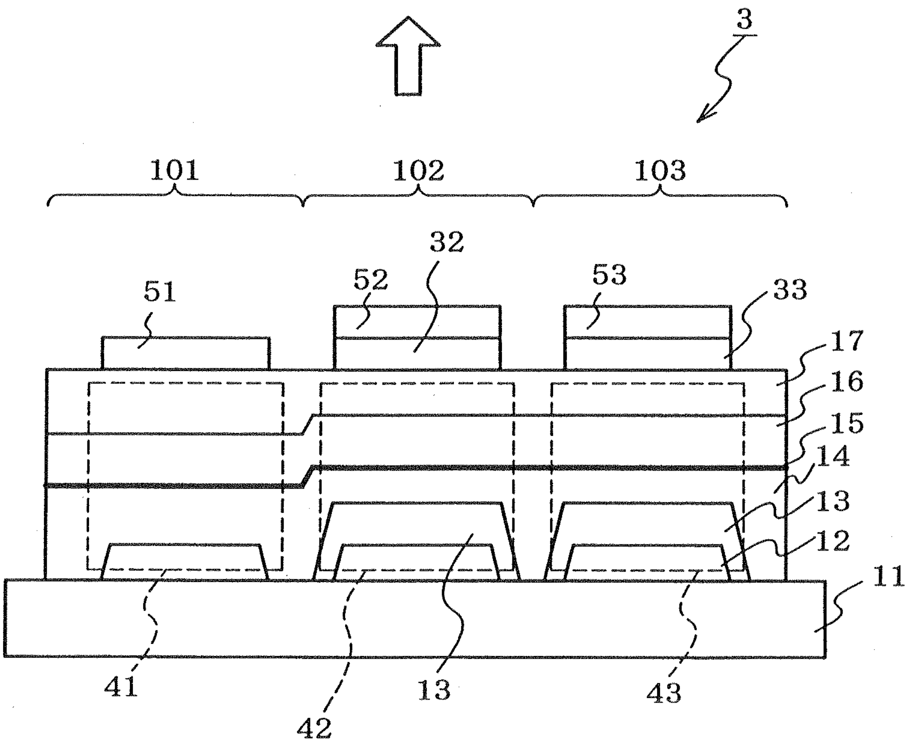
3
101
102
103
32
52
53
51
33
17
16
15
14
13
12
11
41
42
13
43

FIG. 7

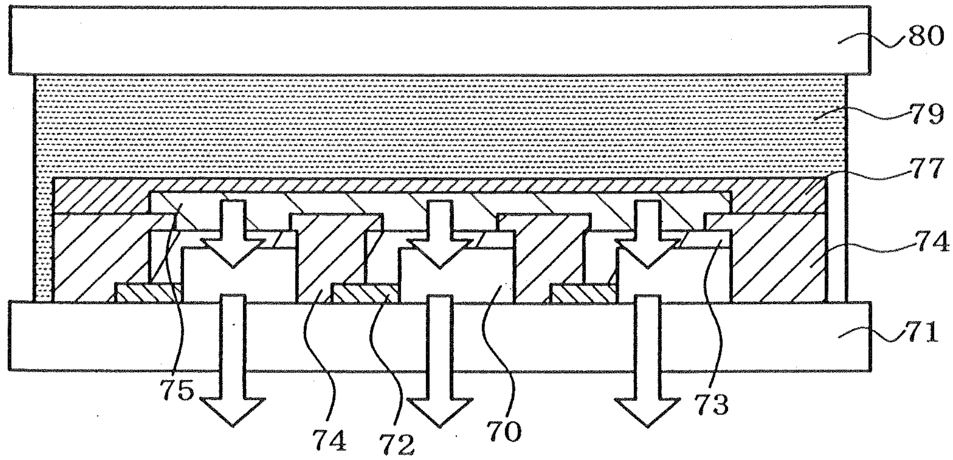


FIG. 8

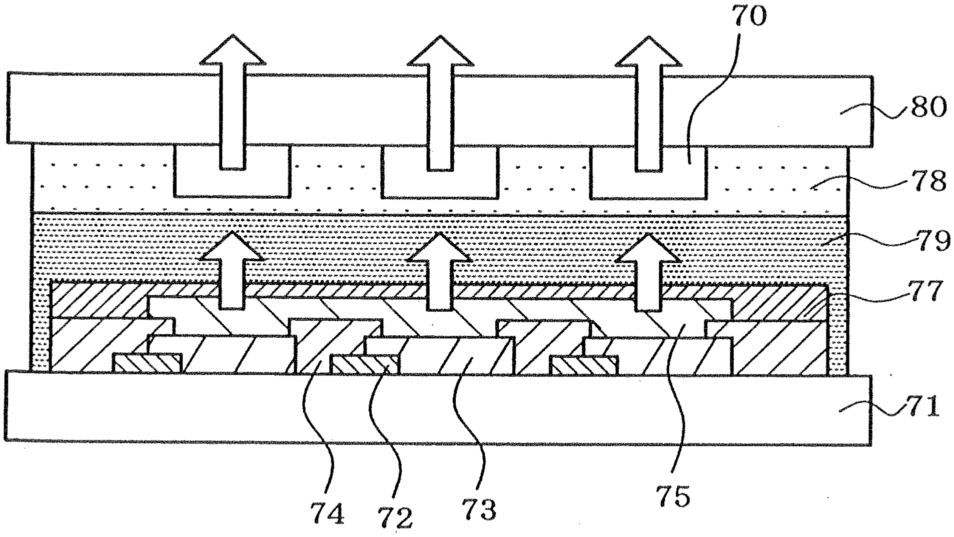

FIG. 9

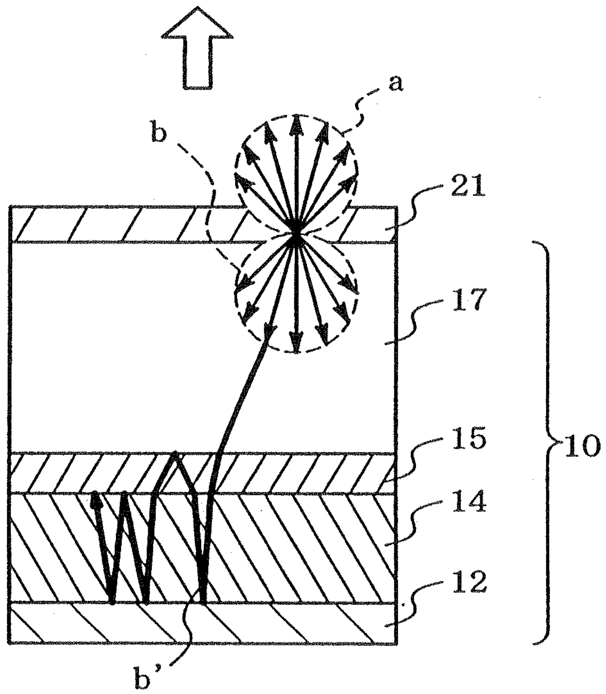

## INTERNATIONAL SEARCH REPORT

International application No.
PCT/JP2005/012936

A. CLASSIFICATION OF SUBJECT MATTER
Int.Cl$^7$ H05B33/22, 33/14, 33/24

According to International Patent Classification (IPC) or to both national classification and IPC

B. FIELDS SEARCHED

Minimum documentation searched (classification system followed by classification symbols)
Int.Cl$^7$ H05B33/22, 33/14, 33/24

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2004-14335 A (Konica Minolta Holdings Kabushiki Kaisha), 15 January, 2004 (15.01.04), Fig. 5(a); Par. Nos. [0221], [0049] (Family: none) | 1-7,14<br>11-13 |
| Y | JP 2002-520801 A (Motorola, Inc.), 09 July, 2002 (09.07.02), Claim 1; Par. Nos. [0013] to [0015]; Fig. 4 & US 2000/6140764 A & WO 2000/04594 A | 11-13 |
| A | JP 2000-68069 A (Idemitsu Kosan Co., Ltd.), 03 March, 2000 (03.03.00), Fig. 4; Par. No. [0055] (Family: none) | 1-14 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 12 September, 2005 (12.09.05) | 27 September, 2005 (27.09.05) |
| Name and mailing address of the ISA/<br>Japanese Patent Office | Authorized officer |
| Facsimile No. | Telephone No. |

Form PCT/ISA/210 (second sheet) (January 2004)

INTERNATIONAL SEARCH REPORT

International application No. PCT/JP2005/012936

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-227811 A (Fuji Electric Holdings Co., Ltd.), 12 August, 2004 (12.08.04), Full text; all drawings (Family: none) | 1-14 |
| A | JP 2004-258586 A (Dainippon Printing Co., Ltd.), 16 September, 2004 (16.09.04), Front page; column of "Problems"; Fig. 1(c); Par. No. [0026] (Family: none) | 1-14 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 10289784 A
- JP 2000077191 A
- JP 2002520801 A
- JP 2004042694 A
- EP 0281381 A
- JP 2003249372 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 8193191 A
- JP 11279426 A
- JP 2002510866 A